# EUROPEAN PATENT APPLICATION

(11) **EP 4 645 291 A1**
(43) Date of publication of application: **05.11.2025**
(21) Application number: 24832191.1
(22) Date of filing: 08.04.2024
(51) Int. Cl.: G09F 9/302, G06F 1/10, H01L 25/075, H10H 29/01, G09F 9/33

(54) **DISPLAY APPARATUS**

(30) Priority: 30.06.2023 KR 20230085272
(71) Applicant: Samsung Electronics Co., Ltd., Suwon-si, Gyeonggi-do 16677 (KR)
(72) Inventor: OH, Pilyong, Suwon-si, Gyeonggi-do 16677 (KR); KIM, Seungjae, Suwon-si, Gyeonggi-do 16677 (KR); KIM, Jisu, Suwon-si, Gyeonggi-do 16677 (KR); LEE, Kwangjae, Suwon-si, Gyeonggi-do 16677 (KR)
(74) Representative: Appleyard Lees IP LLP
(86) International application number: PCT/KR2024/004606
(87) International publication number: WO 2025/005406

(57) **Abstract**

A display apparatus includes: a plurality of display modules; and a frame configured to support the plurality of display modules in a matrix arrangement. The frame includes: a first module attachment layer having a first thermal expansion coefficient; a first frame panel coupled to the first module attachment layer and having a second thermal expansion coefficient; and a second module attachment layer to which remaining display modules of the plurality of display modules are attached, having the first thermal expansion coefficient; a second frame panel coupled to the second module attachment layer and having the second thermal expansion coefficient; a first fixing member configured to fix a first portion on the first module attachment layer and a first portion on the first frame panel; a second fixing member configured to fix a first portion on the second module attachment layer and a first portion on the second frame panel.

## Description

### [Technical Field]

The disclosure relates to a display apparatus that displays images by combining modules in which self-luminous elements are disposed on a substrate.

### [Background Art]

A display apparatus is an output device that visually displays data information, such as letters and shapes, and images.

In general, a liquid crystal panel that requires a backlight, or an organic light emitting diode (OLED) panel formed of a film of organic compounds that is self-luminous in response to an electric current is mainly used as a display apparatus. However, the liquid crystal panel has a slow response time, high power consumption, and is not self-luminous requiring a backlight. As a result, liquid crystal panels are usually not compact. Because the OLED panel is self-luminous, the OLED panel does not require a backlight and may be made thin. However, when the same image is displayed for a long period of time, the OLED panel is vulnerable to a burn-in (deterioration) phenomenon, in which a certain part of the previous image remains even when the image changes. This often happens near the end of the life of the subpixels.

Accordingly, as a new panel to replace these panels, a micro light emitting diode (micro LED or µLED) display panel in which inorganic light-luminous elements are mounted on a substrate and the inorganic light-luminous elements themselves are used as pixels, is being studied.

The micro light emitting diode display panel (hereinafter referred to as micro LED panel), which is one of the flat display panels, is composed of a plurality of inorganic light emitting diodes (inorganic LEDs) each of which is equal to or less than 100 micrometers.

Although micro LED panels are also composed of light-luminous elements, the burn-in phenomenon that occurs in the OLED panel does not occur in micro LED panels, and micro LED panels can have excellent brightness, resolution, power consumption, and durability.

Compared to a liquid crystal display (LCD) panel that requires a backlight, the micro LED display panel offers better contrast, response time and energy efficiency. Both the organic light emitting diode (organic LED) and micro LED (inorganic light emitting elements) have good energy efficiency, but the micro LED has excellent brightness and luminous efficiency and a long lifespan compared to the OLED.

In addition, the micro LED may be manufactured as a display module in a substrate unit by arranging LEDs in a pixel unit on a circuit board, and may be easily manufactured with various resolutions and screen sizes to suit consumer orders.

### [Disclosure]

### [Technical Problem]

The disclosure can provide a display apparatus capable of preventing increase in seams that may occur between a plurality of display modules by keeping gaps between the plurality of display modules due to thermal expansion at a certain level.

One or more embodiments of the disclosure provide a display apparatus, despite including a plurality of frames, that may prevent seams between a plurality of display modules supported by the plurality of frames from increasing due to thermal expansion.

Aspects to be achieved in this document are not limited to the aspects mentioned above, and other aspects not mentioned will be clearly understood by those skilled in the art from the description below.

### [Technical Solution]

According to an aspect of the disclosure, a display apparatus may include: a plurality of display modules; and a frame supporting the plurality of display modules in a matrix arrangement. The frame may include: a first module attachment layer to which some display modules among the plurality of display modules are attached and having a first thermal expansion coefficient; a first frame panel coupled to the first module attachment layer and having a second thermal expansion coefficient different from the first thermal expansion coefficient; a second module attachment layer to which remaining display modules of the plurality of display modules are attached, having the first thermal expansion coefficient, and disposed adjacently with the first module attachment layer; a second frame panel coupled to the second module attachment layer, having the second thermal expansion coefficient, and disposed adjacently with the first frame panel; a first fixing member configured to fix a first portion on the first module attachment layer and a first portion on the first frame panel so that the first portion on the first module attachment layer and the first portion on the first frame panel do not move relative to each other as the first module attachment layer and the first frame panel thermally expand; and a second fixing member configured to fix a first portion on the second module attachment layer and a first portion on the second frame panel so that the first portion on the second module attachment layer and the first portion on the second frame panel do not move relative to each other as the second module attachment layer and the second frame panel thermally expand.

According to an aspect of the disclosure, a display apparatus including a plurality of display modules, and a frame provided to support the plurality of display modules so that the plurality of display modules is arranged horizontally in the form of an M*N matrix. The frame includes a plurality of module attachment layers to which the plurality of display modules is attached, having a first thermal expansion coefficient and arranged horizontally in the form of a 2*2 matrix, a plurality of frame panels coupled to the plurality of module attachment layers, having a second thermal expansion coefficient different from the first thermal expansion coefficient, and arranged horizontally in the form of a 2*2 matrix, and a plurality of fixing members provided to fix first portions of the plurality of respective module attachment layers and first portions of the plurality of respective frame panels so that the first portions of the plurality of respective module attachment layers and the first portions of the plurality of respective frame panels corresponding to the first portions of the plurality of respective module attachment layers do not move relative to each other in a horizontal direction
According to an aspect of the disclosure, a display apparatus may include: a plurality of display modules, each of the plurality of display modules may include a substrate having a first thermal expansion coefficient; and a frame supporting the plurality of display modules in a matrix arrangement. The frame may include: a module attachment layer to which the plurality of display modules are attached and having the first thermal expansion coefficient; a frame panel coupled to the module attachment layer and having a second thermal expansion coefficient different from the first thermal expansion coefficient; and an adhesive layer between the module attachment layer and the frame panel to adhere the module attachment layer and the frame panel, the adhesive layer having a ductility that is greater than a ductility of the module attachment layer and a ductility of the frame panel.

### [Description of Drawings]

FIG. 1 illustrates a display apparatus according to one or more embodiments;
FIG. 2 is an exploded view of main components of the display apparatus according to one or more embodiments;
FIG. 3 is an enlarged cross-sectional view of some components of a display module of the display apparatus according to one or more embodiments;
FIG. 4 is a rear view of the display module of the display apparatus according to one or more embodiments;
FIG. 5 illustrates a frame in the display apparatus according to one or more embodiments;
FIG. 6 is an exploded view of the frame in the display apparatus according to one or more embodiments;
FIG. 7 is a front view of the frame in the display apparatus according to one or more embodiments;
FIG. 8 schematically illustrates the frame illustrated in FIG. 7;
FIG. 9 schematically illustrates an appearance of the frame when thermally expanded in the display apparatus according to one or more embodiments;
FIG. 10 illustrates an example of a fixing member in the display apparatus according to one or more embodiments;
FIG. 11 illustrates an example of a fixing member in the display apparatus according to one or more embodiments;
FIG. 12 schematically illustrates a frame in the display apparatus according to one or more embodiments;
FIG. 13 schematically illustrates an appearance of the frame when thermally expanded in the display apparatus according to one or more embodiments;
FIG. 14 schematically illustrates a frame in the display apparatus according to one or more embodiments; and
FIG. 15 schematically illustrates a frame in the display apparatus according to one or more embodiments.

### [Mode of the Disclosure]

Various embodiments and terms in this document are not intended to limit the technical features described in this document to specific embodiments, and should be understood to include various modifications, equivalents, or substitutes of the embodiments.

In connection with the description of the drawings, like reference numbers may be used for like or related elements.

The singular form of a noun corresponding to an item may include one item or a plurality of items, unless the relevant context clearly dictates otherwise.

In this document, each of phrases such as "A or B," "at least one of A and B," "at least one of A or B," "A, B or C," "at least one of A, B and C," and "at least one of A, B, or C" may include any one of the items listed together in the corresponding one of the phrases, or all possible combinations thereof.

The term "and/or" includes any combination of a plurality of related components or any one of a plurality of related components.

Terms such as "first," "second," "primary," and "secondary" may simply be used to distinguish a given component from other corresponding components, and do not limit the corresponding components in any other respect (e.g., importance or order).

When any (e.g., first) component is referred to as being "coupled" or "connected" to another (e.g., second) component with or without the terms "functionally" or "communicatively", this means that the any component may be connected to the other component directly (e.g., by wire), wirelessly, or through a third component.

The terms "comprises" and "has" are intended to indicate that there are features, numbers, steps, operations, components, parts, or combinations thereof described in this document, and do not exclude the presence or addition of one or more other features, numbers, steps, operations, components, parts, or combinations thereof.

When any component is referred to as being "connected", "coupled", "supported" or "in contact" with another component, this includes a case in which the components are indirectly connected, coupled, supported, or in contact with each other through a third component as well as directly connected, coupled, supported, or in contact with each other.

When any component is referred to as being located "on" or "over" another component, this includes not only a case in which any component is in contact with another component but also a case in which another component is present between the two components.

Expressions related to direction such as terms "front," "rear," "left," "right," "up," "down," etc. used in the description below are defined based on the drawings, and the like used in the following description are defined with reference to the drawings, and the shape and position of each component are not limited by these terms.

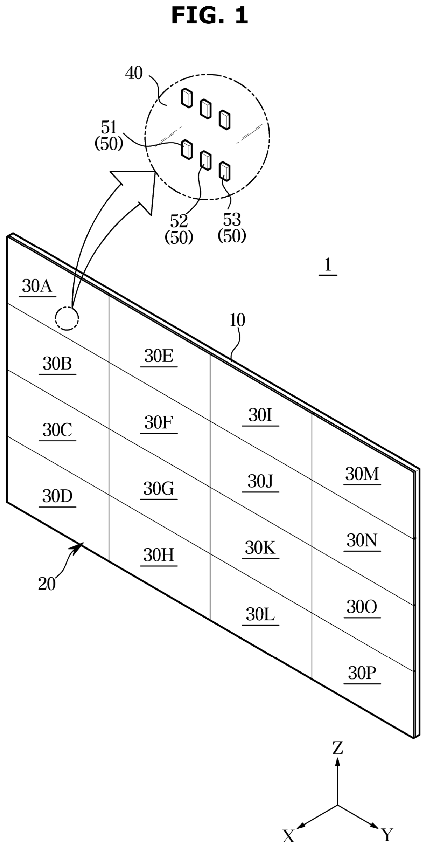

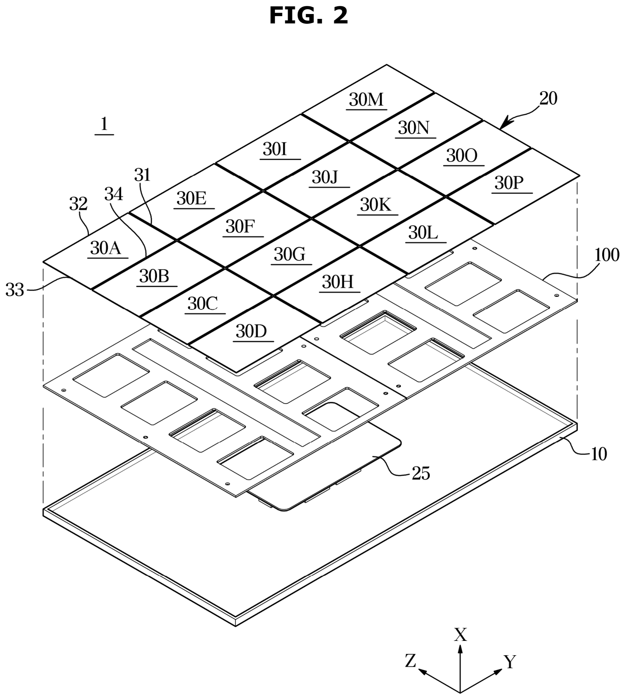

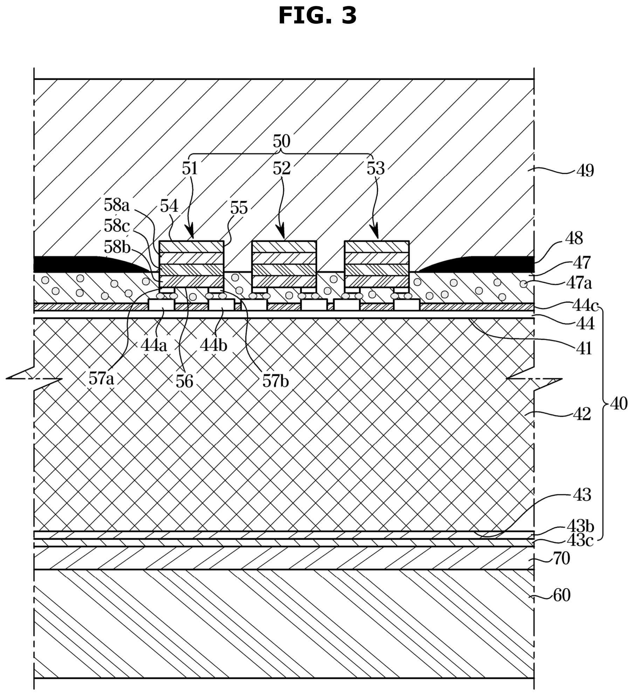

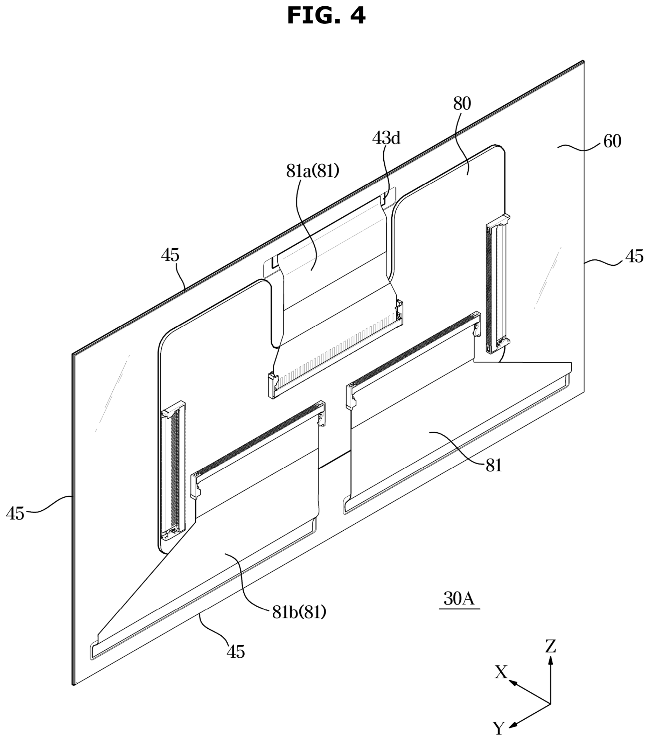

FIG. 1 illustrates a display apparatus according to one or more embodiments. FIG. 2 is an exploded view of main components of the display apparatus according to one or more embodiments. FIG. 3 is an enlarged cross-sectional view of some components of a display module of the display apparatus according to one or more embodiments. FIG. 4 is a rear view of the display module of the display apparatus according to one or more embodiments.

Some components of a display apparatus 1, including a plurality of inorganic light emitting elements 50 illustrated in the drawings, are micro-scale components having a size of several µm to hundreds of µm, and for convenience of explanation, some components (the plurality of inorganic light emitting elements 50, a black matrix 48, etc.) are illustrated at exaggerated scales.

The display apparatus 1 is an apparatus provided to display information, materials, data, etc. in the form of characters, shapes, graphs, images, etc., and a TV, PC, mobile, digital signage, etc. may be implemented with the display apparatus 1.

According to one or more embodiments of the disclosure, as illustrated in FIGS. 1 and 2, the display apparatus 1 may include a display panel 20 provided to display an image, a board 25 for driving and/or controlling the display panel 20, a frame 100 provided to support the display panel 20, and a rear cover 10 provided to cover a rear surface of the frame 100.

The display panel 20 may include a plurality of display modules 30A-30P, a driving board provided to drive each of the display modules 30A-30P, and a timing controller board (TCON board) provided to generate a timing signal necessary for controlling each of the display modules 30A-30P.

The board 25 may include a circuit board for driving and/or controlling the display apparatus 1. As one or more examples, the board 25 may include at least one of a power board for supplying power to the display panel 20, a control board for controlling the overall operation of the display panel 20, and a communication board for communication with an external device.

The rear cover 10 may support the display panel 20. The rear cover 10 may be installed on a floor through a stand, or may be installed on a wall through a hanger.

The plurality of display modules 30A-30P may be arranged up, down, left and right so as to be adjacent to each other. The plurality of display modules 30A-30P may be arranged in the form of an M * N matrix. In this embodiment, the plurality of display modules 30A-30P is provided in 16 pieces and arranged in the form of a 4 * 4 matrix, but there is no limit to the number and arrangement of the plurality of display modules 30A-30P.

The plurality of display modules 30A-30P may be installed on the frame 100. The plurality of display modules 30A-30P may be installed on the frame 100 through various known methods, such as a magnetic force using a magnet, mechanical fitting structure, and adhesion. The rear cover 10 is coupled to the rear of the frame 100, and may form a rear exterior of the display apparatus 1. The frame 100 may include a plurality of module openings 100a formed to correspond to the plurality of display modules 30A-30P.

The rear cover 10 may include a metal material. Accordingly, heat generated from the plurality of display modules 30A-30P and the frame 100 may be easily conducted to the rear cover 10 to increase heat dissipation efficiency of the display apparatus 1.

The display apparatus 1 according to various embodiments may implement a large screen by tiling the plurality of display modules 30A-30P.

Unlike this embodiment of the disclosure, each of the plurality of display modules 30A-30P may be applied to a display apparatus. The display modules 30A-30P may be installed and applied as a single unit to a wearable device, a portable device, a handheld device, and various electronic products or electrical equipment that require various displays, and as in the embodiment of the disclosure, may be applied to display apparatus such as a monitor for a personal computer (PCs), a high-resolution TV and signage, an electronic display, and the like through a plurality of assembly arrangements in a matrix type.

The plurality of display modules 30A-30P may have the same configuration. Therefore, a description of one display module described below may be equally applied to all the other display modules.

For example, the first display module 30A among the plurality of display modules 30A-30P may be formed in a quadrangle type. The first display module 30A may be provided in a rectangular (rectangular type) shape or square (square type) shape.

The first display module 30A may include edges 31, 32, 33, and 34 formed in upward, downward, left, and right directions based on a first direction X, which is the front.

As illustrated in FIG. 3, the plurality of display modules 30A-30P may each include a substrate 40 and the plurality of inorganic light emitting elements 50 mounted (disposed) on the substrate 40. The plurality of inorganic light emitting elements 50 may be mounted on a mounting surface 41 of the substrate 40 facing in the first direction X. FIG. 3 shows a thickness of the substrate 40 in the first direction X to be exaggeratedly thick for convenience of explanation.

The substrate 40 may be formed in a quadrangle type. As described above, each of the plurality of display modules 30A-30P may be provided in a quadrangle shape, and the substrate 40 may be formed in a quadrangle type to correspond thereto.

The substrate 40 may be provided in a rectangular (rectangular type) shape or a square (square type) shape.

Taking the first display module 30A as one or more examples, the substrate 40 may include four edges corresponding to the edges 31, 32, 33, and 34 of the first display module 30A formed in the upward, downward, left, and right directions based on the first direction X, which is the front.

The substrate 40 may include a base substrate 42, the mounting surface 41 forming one surface of the base substrate 42, a rear surface 43 forming the other surface of the base substrate 42 and disposed on the opposite side to the mounting surface 41, and a side surface 45 disposed between the mounting surface 41 and the rear surface 43.

The substrate 40 may include a thin film transistor (TFT) layer 44 formed on the base substrate 42 to drive the inorganic light emitting elements 50. The base substrate 42 may include a glass substrate. The substrate 40 may include a chip on glass (COG) type substrate. The substrate 40 may include first and second pad electrodes 44a and 44b provided to electrically connect the inorganic light emitting elements 50 to the TFT layer 44.

A thin film transistor (TFT) constituting the TFT layer 44 is not limited to a specific structure or type and may be configured with various embodiments. The TFT of the TFT layer 44 according to one or more embodiments may be implemented not only with a low temperature poly silicon (LTPS) TFT, an oxide TFT, and a Si (poly silicon or a-silicon) TFT, but also with an organic TFT and a graphene TFT.

The TFT layer 44 may be replaced with a complementary metal-oxide semiconductor (CMOS) type, n-type MOSFET, or p-type MOSFET transistor when the base substrate 42 of the substrate 40 is provided as a silicon wafer.

The plurality of inorganic light emitting elements 50 is formed of inorganic materials, and may include inorganic light emitting elements each having a length of several µm to tens of µm in width, length, and height. The micro-inorganic light emitting element may have a short side length of 100 µm or less among the width, length, and height. The inorganic light emitting element 50 may be picked up from a wafer made of sapphire or silicon and directly transferred onto the substrate 40. The plurality of inorganic light emitting elements 50 may be picked up and transferred through an electrostatic method using an electrostatic head or a stamp method using an elastic polymer material such as PDMS or silicon as a head.

The plurality of inorganic light emitting elements 50 may be a light emitting structure including an n-type semiconductor 58a, an active layer 58c, a p-type semiconductor 58b, a first contact electrode 57a, and a second contact electrode 57b.

One of the first contact electrode 57a and the second contact electrode 57b may be electrically connected to the n-type semiconductor 58a, and the other may be electrically connected to the p-type semiconductor 58b.

The first contact electrode 57a and the second contact electrode 57b may be in the form of a flip chip arranged horizontally and arranged toward the same direction (direction opposite to a direction of light emission).

The inorganic light emitting element 50 has a light emitting surface 54 disposed toward the first direction X when mounted on the mounting surface 41, a side surface 55, and a bottom surface 56 disposed on the opposite side of the light emitting surface 54, and the first contact electrode 57a and the second contact electrode 57b may be formed on the bottom surface 56.

The contact electrodes 57a and 57b of the inorganic light emitting element 50 are disposed on the opposite side of the light emitting surface 54, and thus may be disposed on the opposite side of a direction in which light is irradiated.

The contact electrodes 57a and 57b are disposed to face the mounting surface 41 to be electrically connected to the TFT layer 44, and the light emitting surface 54 irradiating light in a direction opposite to a direction in which the contact electrodes 57a and 57b are disposed may be disposed.

When light generated from the active layer 58c is irradiated in the first direction through the light emitting surface 54, the light may be irradiated toward the first direction X without interference from the first contact electrode 57a or the second contact electrode 57b.

The first direction X may be defined as a direction to which the light emitting surface 54 irradiating light directs. For example, the first direction X may point the front.

The first contact electrode 57a and the second contact electrode 57b may be electrically connected to the first pad electrode 44a and the second pad electrode 44b formed on the mounting surface 41 side of the substrate 40, respectively.

The inorganic light emitting element 50 may be directly connected to the pad electrodes 44a and 44b through an anisotropic conductive layer 47 or an adhering structure such as solder.

The anisotropic conductive layer 47 may be formed on the substrate 40 to mediate electrical connection between the contact electrodes 57a and 57b and the pad electrodes 44a and 44b. The anisotropic conductive layer 47 is formed by attaching an anisotropic conductive adhesive onto a protective film, and may have a structure in which conductive balls 47a are dispersed in adhesive resin. The conductive ball 47a is a conductive sphere surrounded by a thin insulating film, and may electrically connect one conductor to another as the insulating film is broken by heat and pressure.

The anisotropic conductive layer 47 may include an anisotropic conductive film (ACF) in the form of a film and an anisotropic conductive paste (ACP) in the form of a paste.

When heat and pressure are applied to the anisotropic conductive layer 47 when the plurality of inorganic light emitting elements 50 is mounted on the substrate 40, the insulating film of the conductive ball 47a may be broken so that the contact electrodes 57a and 57b of the inorganic light emitting element 50 and the pad electrodes 44a and 44b of the substrate 40 may be electrically connected.

However, the plurality of inorganic light emitting elements 50 may be mounted on the substrate 40 through solder instead of the anisotropic conductive layer 47. After the inorganic light emitting elements 50 are aligned on the substrate 40, the inorganic light emitting elements 50 may be adhered to the substrate 40 through a reflow process.

The plurality of inorganic light emitting elements 50 may include a red light emitting element 51, a green light emitting element 52, and a blue light emitting element 53, and may be mounted on the mounting surface 41 of the substrate 40 with forming a series of the red light emitting element 51, green light emitting element 52, and blue light emitting element 53 as one unit. A series of the red light emitting element 51, green light emitting element 52, and blue light emitting element 53 may form one pixel. In this case, the red light emitting element 51, green light emitting element 52, and blue light emitting element 53 may each form a subpixel.

For example, the red light emitting element 51, the green light emitting element 52, and the blue light emitting element 53 may be arranged in a row at a predetermined interval, or may be arranged in other forms such as a triangular shape.

The substrate 40 may include a light absorbing layer 44c to improve contrast by absorbing external light. The light absorbing layer 44c may be formed on the entire mounting surface 41 of the substrate 40. The light absorbing layer 44c may be formed between the TFT layer 44 and the anisotropic conductive layer 47.

The plurality of display modules 30A-30P may further include black matrices 48 formed between the plurality of inorganic light emitting elements 50.

The black matrix 48 may perform a function of supplementing the light absorbing layer 44c formed entirely on the mounting surface 41 side of the substrate 40. The black matrix 48 may absorb external light to make the substrate 40 appear black, thereby improving screen contrast. The black matrix 48 may have a black color.

According to one or more embodiments, the black matrix 48 may be formed to be disposed between the pixels formed by a series of the red light emitting elements 51, green light emitting elements 52, and blue light emitting elements 53. Alternatively, the black matrix may be formed in more detail to partition each of the light emitting elements 51, 52, and 53, which are the subpixels.

The black matrix 48 may be formed in a grid shape with horizontal and vertical patterns to be disposed between the pixels.

The black matrix 48 may be formed by applying light-absorbing ink on the anisotropic conductive layer 47 through an ink-jet process and then curing the applied light-absorbing ink, or may be formed by coating the anisotropic conductive layer 47 with a light-absorbing film.

The black matrices 48 may be formed in a region in which the plurality of inorganic light emitting elements 50 is not mounted on the anisotropic conductive layer 47 formed entirely on the mounting surface 41. The black matrices 48 may be formed between the plurality of inorganic light emitting elements 50.

The plurality of display modules 30A-30P may each include a front cover 49 disposed on the mounting surface 41 in the first direction X to cover the mounting surface 41 of the plurality of display modules 30A-30P.

A plurality of the front covers 49 may be provided to be formed in the first direction X on the plurality of display modules 30A-30P, respectively.

The front cover 49 may include a film. The film of the front cover 49 may be formed of a functional film with optical performance.

The front cover 49 may be provided to cover the substrate 40 to protect the substrate 40 from an external force.

An adhesive layer of the front cover 49 may be provided to have a height greater than or equal to a predetermined height in the first direction X toward which the mounting surface 41 or the light emitting surface 54 faces. This is to sufficiently fill gaps that may be formed between the front covers 49 and the plurality of inorganic light emitting elements 50 when the front covers 49 are disposed on the substrate 40.

Each of the plurality of display modules 30A-30P may include a heat dissipation member 60 provided on the rear surface 43 of the substrate 40. The heat dissipation member 60 may be provided to dissipate heat generated from the substrate 40.

The heat generated from the substrate 40 may include heat generated from various components. Heat that accounts for the largest proportion of the heat generated from the substrate 40 and transferred to the rear surface 43 is heat generated when the plurality of inorganic light emitting elements 50 emits light. In addition, heat may be generated from a plurality of components disposed on the mounting surface 41 of the substrate 40, such as the TFT layer 44, and the heat generated from the plurality of components may be introduced into the substrate 40.

In addition, heat may be transferred to the substrate 40 from the outside of the substrate 40, and heat may be transferred to the substrate 40 through components other than the substrate 40, thereby generating heat in the substrate 40.

The heat generated from the substrate 40 to be described below refers to heat substantially generated from a plurality of components, which is disposed on the substrate 40 including the plurality of inorganic light emitting elements 50, and then introduced into the substrate 40.

As described above, most of the heat generated from the plurality of inorganic light emitting elements 50 is introduced into the substrate 40, and the largest proportion of the heat generated from the substrate 40 is the heat generated from the plurality of inorganic light emitting elements 50. However, as described above, it may be expressed that heat is generated in the substrate 40 by heat generated from various components and the outside of the substrate 40 in addition to the plurality of inorganic light emitting elements 50.

Each of the plurality of display modules 30A-30P may include an adhesive tape 70 disposed between the rear surface 43 and the heat dissipation member 60 to adhere the rear surface 43 of the substrate 40 and the heat dissipation member 60.

The plurality of inorganic light emitting elements 50 may be electrically connected to a pixel driving wiring formed on the mounting surface 41 and a top wiring layer extending through the side surface 45 of the substrate 40 and formed of the pixel driving wiring.

The top wiring layer may be electrically connected to a side wiring formed on the side surface 45 of the substrate 40. The side wiring may be provided in a thin film form.

The top wiring layer may be connected to the side wiring by a top connection pad formed on the edges side of the substrate 40.

The side wiring may extend along the side surface 45 of the substrate 40 to be connected to a rear wiring layer 43b formed on the rear surface 43.

An insulating layer 43c provided to cover the rear wiring layer 43b may be formed on the rear wiring layer 43b in a direction in which the rear surface of the substrate 40 faces.

That is, the plurality of inorganic light emitting elements 50 may be sequentially electrically connected to the top wiring layer, the side wiring, and the rear wiring layer 43b.

Referring to FIG. 4, the first display module 30A may include a driving circuit board 80 provided to electrically control the plurality of inorganic light emitting elements 50 mounted on the mounting surface 41. The driving circuit board 80 may be formed of a printed circuit board. The driving circuit board 80 may be disposed on the rear surface 43 of the substrate 40 in the first direction X. Specifically, the driving circuit board 80 may be disposed on the heat dissipation member 60 adhered to the rear surface 43 of the substrate 40.

The first display module 30A may include a flexible film 81 provided to connect the driving circuit board 80 and the rear wiring layer 43b so that the driving circuit board 80 is electrically connected to the plurality of inorganic light emitting elements 50.

One end of the flexible film 81 may be connected to a rear connection pad 43d disposed on the rear surface 43 of the substrate 40 and electrically connected to the plurality of inorganic light emitting elements 50.

The rear connection pad 43d may be electrically connected to the rear wiring layer 43b. Accordingly, the rear connection pad 43a may electrically connect the rear wiring layer 43b and the flexible film 81.

The flexible film 81 may transmit power and electrical signals from the driving circuit board 80 to the plurality of inorganic light emitting elements 50 by being electrically connected to the rear connection pad 43d.

The flexible film 81 may be formed of a flexible flat cable (FFC) or chip on film (COF).

The flexible film 81 may include a first flexible film 81a and a second flexible film 81b disposed in the upward and downward directions, respectively, with respect to the first direction X, which is the front.

Unlike this, the first flexible film 81a and the second flexible film 81b may be disposed in the left and right directions with respect to the first direction X, or may be disposed in at least two directions among the upward, downward, left, and right directions, respectively.

A plurality of the second flexible films 81b may be provided. However, embodiments of the present disclosure are not limited thereto and the single second flexible film 81b may be provided, and a plurality of the first flexible films 81a may also be provided.

The first flexible film 81a may transmit a data signal from the driving circuit board 80 to the substrate 40. The first flexible film 81a may be provided as a chip on film (COF).

The second flexible film 81b may transmit power from the driving circuit board 80 to the substrate 40. The second flexible film 81b may be provided as a flexible flat cable (FFC).

However, embodiments of the present disclosure are not limited thereto, and the first flexible film 81a and the second flexible film 81b may be formed as opposite elements.

The driving circuit board 80 may be electrically connected to the main board 25 (see FIG. 2). The board 25 may be disposed on a rear side of the frame 100, and may be connected to the driving circuit board 80 through a cable at the rear of the frame 100.

The heat dissipation member 60 may be provided to be in contact with the substrate 40. The heat dissipation member 60 and the substrate 40 may be adhered to each other by the adhesive tape 70 disposed between the rear surface 43 of the substrate 40 and the heat dissipation member 60.

The heat dissipation member 60 may be formed of a material with high thermal conductivity or may be implemented in a configuration with high thermal conductivity. As one or more examples, the heat dissipation member 60 may be provided as a graphite sheet. As one or more examples, the heat dissipation member 60 may be made of aluminum.

Heat generated from the plurality of inorganic light emitting elements 50 and the TFT layer 44 mounted on the substrate 40 may be transferred to the heat dissipation member 60 through the adhesive tape 70 along the rear surface 43 of the substrate 40.

Accordingly, heat generated in the substrate 40 may be easily transferred to the heat dissipation member 60 and the substrate 40 may be prevented from rising above a certain temperature.

The plurality of display modules 30A-30P may be arranged in various positions in the form of the M * N matrix, respectively. Each of the display modules 30A-30P is provided to be individually movable. In this case, the display modules 30A-30P may each individually include the heat dissipation member 60, so that regardless of where each of the display modules 30A-30P is positioned, a certain level of heat dissipation performance may be maintained.

The plurality of display modules 30A-30P may form screens of various sizes of the display apparatus 1 in various forms of the M * N matrix. Accordingly, compared to heat dissipation through a single heat dissipation member provided for heat dissipation of all of the plurality of display modules 30A-30P, as in one or more embodiments of the present disclosure, as each of the display modules 30A-30P includes the independent heat dissipation member 60, individual heat dissipation of each of the display modules 30A-30P may improve the heat dissipation performance of the entire display apparatus 1.

When a single heat dissipation member is disposed inside the display apparatus 1, a portion of the heat dissipation member may not be disposed in positions corresponding to positions where some display modules are disposed based on forward and rearward directions, and the heat dissipation member may be disposed in a position where the display module is not disposed, so that the heat dissipation efficiency of the display apparatus 1 may be reduced.

That is, through the heat dissipation member 60 disposed in each of the display modules 30A-30P, regardless of where each of the display modules 30A-30P is disposed, all of the display modules 30A-30P may enable their own heat dissipation through each heat dissipation member 60, thereby improving the heat dissipation performance of the entire display apparatus 1.

The heat dissipation member 60 may be provided in a quadrangle shape substantially corresponding to the shape of the substrate 40.

An area of the substrate 40 may be provided to be at least equal to or larger than an area of the heat dissipation member 60. When the substrate 40 and the heat dissipation member 60 are arranged side by side in the first direction X, the four edges of the substrate 40 having a rectangular shape based on a center of the substrate 40 and the heat dissipation member 60 may be formed to correspond to four edges of the heat dissipation member 60, or may be provided to be positioned further outside than the four edges of the heat dissipation member 60 based on the center of the substrate 40 and the heat dissipation member 60.

Appropriately, the four edges of the substrate 40 may be provided to be positioned further outside than the four edges of the heat dissipation member 60. That is, the area of the substrate 40 may be provided to be larger than the area of the heat dissipation member 60.

This is because the substrate 40 and the heat dissipation member 60 may be thermally expanded when heat is transferred to each of the display modules 30A-30P, and the heat dissipation member 60 has a thermal expansion coefficient greater than a thermal expansion coefficient of the substrate 40, so that an expansion value of the heat dissipation member 60 may be greater than an expansion value of the substrate 40.

In a case in which the four edges of the substrate 40 correspond to the four edges of the heat dissipation member 60 or are disposed further inside than the four edges of the heat dissipation member 60, when thermally expanded, the edges of the heat dissipation member 60 may protrude to the outside of the substrate 40. Because of this, an interval length between gaps formed between the respective display modules 30A-30P may become irregular due to thermal expansion of the heat dissipation member 60 of each of the display modules 30A-30P. As the interval length becomes irregular, perception of some seams of the display panel 20 may increase and a sense of unity of the screen of the display panel 20 may decrease.

However, in a case in which the four edges of the substrate 40 are provided to be positioned further outside than the four edges of the heat dissipation member 60, the heat dissipation member 60 does not protrude outside the four edges of the substrate 40 even when the substrate 40 and the heat dissipation member 60 are thermally expanded, and thus the interval length of the gaps formed between the respective display modules 30A-30P may be kept regular.

According to one or more embodiments of the present disclosure, the area of the substrate 40 and the area of the heat dissipation member 60 may be provided to substantially correspond to each other. Accordingly, the heat generated in the substrate 40 is not isolated in some regions and may be uniformly dissipated throughout the entire region of the substrate 40.

The heat dissipation member 60 may be provided to be adhered to the rear surface 43 of the substrate 40 using the adhesive tape 70.

The adhesive tape 70 may be provided in a size corresponding to the heat dissipation member 60. That is, an area of the adhesive tape 70 may be provided to correspond to the area of the heat dissipation member 60. The heat dissipation member 60 may be provided in a substantially quadrangle shape, and the adhesive tape 70 may be provided in a quadrangle shape to correspond thereto.

The edges of the heat dissipation member 60 and edges of the adhesive tape 70, which have a rectangular shape based on a center of the heat dissipation member 60 and the adhesive tape 70, may be formed to correspond to each other.

Accordingly, the heat dissipation member 60 and the adhesive tape 70 may be easily manufactured in one combined configuration, thereby increasing a manufacturing efficiency of the entire display apparatus 1.

That is, when the heat dissipation member 60 is cut into unit numbers from one plate, the adhesive tape 70 is pre-adhered to the one plate before the heat dissipation member 60 is cut, and the adhesive tape 70 and the heat dissipation member 60 are cut simultaneously in unit numbers, thereby reducing the number of processes.

Heat generated from the substrate 40 may be transferred to the heat dissipation member 60 through the adhesive tape 70. Accordingly, the adhesive tape 70 may be provided to adhere the heat dissipation member 60 to the substrate 40 and simultaneously transfer heat generated from the substrate 40 to the heat dissipation member 60.

The adhesive tape 70 may include a material with high heat dissipation performance. A material with high heat dissipation performance refers to a material capable of effectively transferring heat due to its high thermal conductivity, high heat transferability, and low specific heat.

The adhesive tape 70 may include a material having adhesive properties to adhere the substrate 40 and the heat dissipation member 60. The adhesive tape 70 may include a material with higher heat dissipation performance than a material with general adhesiveness. Accordingly, heat may be efficiently transferred to each component between the substrate 40 and the heat dissipation member 60.

As one or more examples, the adhesive tape 70 may include a graphite material. However, the adhesive tape 70 is not limited thereto and may be formed of a material with generally high heat dissipation performance.

Ductility of the adhesive tape 70 may be provided to be greater than ductility of the substrate 40 and ductility of the heat dissipation member 60. Therefore, the adhesive tape 70 may be formed of a material having high ductility while having adhesiveness and heat dissipation properties. The adhesive tape 70 may be formed of an inorganic double-sided tape. Because the adhesive tape 70 is formed of an inorganic double-sided tape, the adhesive tape 70 may be formed as a single layer between one surface thereof adhered to the substrate 40 and the other surface thereof adhered to the heat dissipation member 60 without a member for supporting the one surface and the other surface.

Because the adhesive tape 70 does not include the member, the adhesive tape 70 does not include a material that interferes with heat conduction, and thus heat dissipation performance may be improved. However, the adhesive tape 70 is not limited to an inorganic double-sided tape and may be provided as a heat-dissipating tape with better heat dissipation performance than a general double-sided tape.

As one or more examples, in a case in which the substrate 40 is composed of a glass material and the heat dissipation member 60 is composed of a metal material, the material properties of the respective compositions are different, and thus degrees to which the materials are deformed by the same heat may be different. That is, when heat is generated in the substrate 40, the substrate 40 and the heat dissipation member 60 may each be expanded to different sizes due to the heat. Accordingly, the first display module 30A may be damaged.

This is because the expansion values of the substrate 40 and the heat dissipation member 60 at the same temperature are different in a state in which the substrate 40 and the heat dissipation member 60 are fixed to each other, and thus as the substrate 40 and the heat dissipation member 60 are expanded to different sizes, stress may occur in each of the components.

Among the material properties, especially the thermal expansion coefficients of the materials are different so that the degrees to which the materials are physically deformed by heat are different, and in particular, because a thermal expansion coefficient of a metal material is generally greater than that of glass, when the same heat is transferred to the substrate 40 and the heat dissipation member 60, the heat dissipation member 60 may be expanded and be deformed more than the substrate 40.

Conversely, even when the heat generation in the substrate 40 is terminated and the substrate 40 and the heat dissipation member 60 are cooled, respectively, the heat dissipation member 60 may be contracted and deformed more than the substrate 40.

Because the substrate 40 and the heat dissipation member 60 are in a state of being adhered to each other by the adhesive tape 70, when the heat dissipation member 60 is deformed more than the substrate 40, an external force may be transmitted to the substrate 40.

Conversely, an external force may also be transmitted to the heat dissipation member 60 by the substrate 40, but because the rigidity of the glass substrate 40 is less than rigidity of the metal heat dissipation member 60, the substrate 40 may be damaged.

The adhesive tape 70 may be provided to absorb external forces transmitted from different components between the substrate 40 and the heat dissipation member 60 as the substrate 40 and the heat dissipation member 60 are expanded to different sizes. Through this, an external force may be prevented from being transmitted to the substrate 40 and the heat dissipation member 60, and in particular, damage to the substrate 40 may be prevented.

The adhesive tape 70 may be made of a material having high ductility to absorb the external force transmitted from the substrate 40 and the heat dissipation member 60. In detail, the ductility of the adhesive tape 70 may be provided to be greater than the ductility of the substrate 40 and the ductility of the heat dissipation member 60.

Accordingly, when an external force generated from changes in the sizes of the substrate 40 and the heat dissipation member 60 is transmitted to the adhesive tape 70, as the adhesive tape 70 itself is deformed, the external force may be prevented from being transmitted to different components.

The adhesive tape 70 may have a predetermined thickness in the first direction X. When the heat dissipation member 60 be thermally expanded as heat is transferred thereto or the heat dissipation member 60 is cooled and contracted, the heat dissipation member 60 may be expanded or contracted not only in the first direction X, but also in a direction perpendicular to the first direction X, and accordingly, the external force may be transmitted to the substrate 40.

Even when the heat dissipation member 60 is expanded or contracted in the direction perpendicular to the first direction, as the thickness of the adhesive tape 70 changes, an external force may be prevented from being transmitted to the substrate 40. A thermal expansion coefficient of the adhesive tape 70 may be provided to be different from the thermal expansion coefficients of the substrate 40 and the heat dissipation member 60.

According to one or more embodiments, the thermal expansion coefficient of the adhesive tape 70 may be provided to be greater than that of the substrate 40 and less than that of the heat dissipation member 60. Accordingly, the adhesive tape 70 may not be deformed equally to even one of the substrate 40 and the heat dissipation member 60 at the same temperature, and may reduce deformation of each component between the substrate 40 and the heat dissipation member 60. The adhesive tape 70 may easily absorb an external force generated depending on the difference in thermal expansion coefficient between the substrate 40 and the heat dissipation member 60 by being disposed and deformed between the substrate 40 and the heat dissipation member 60.

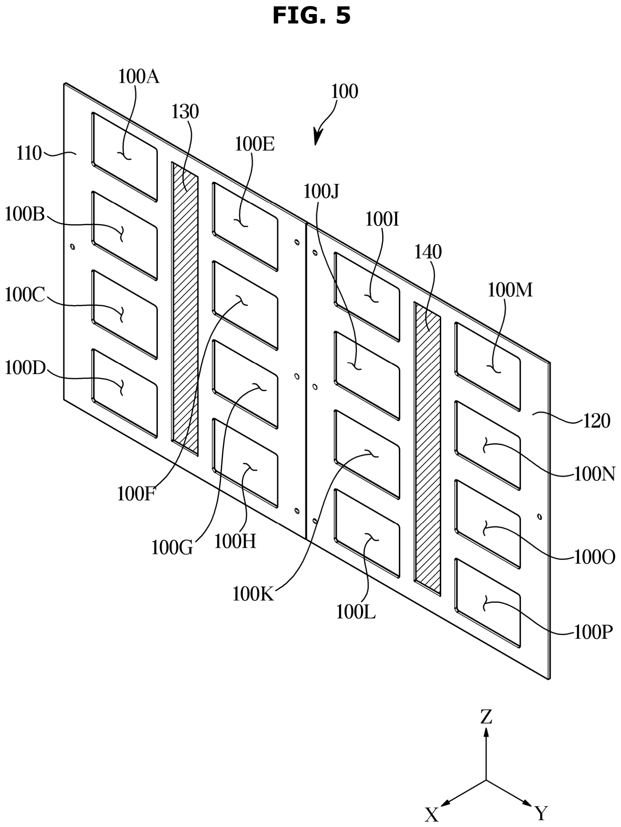

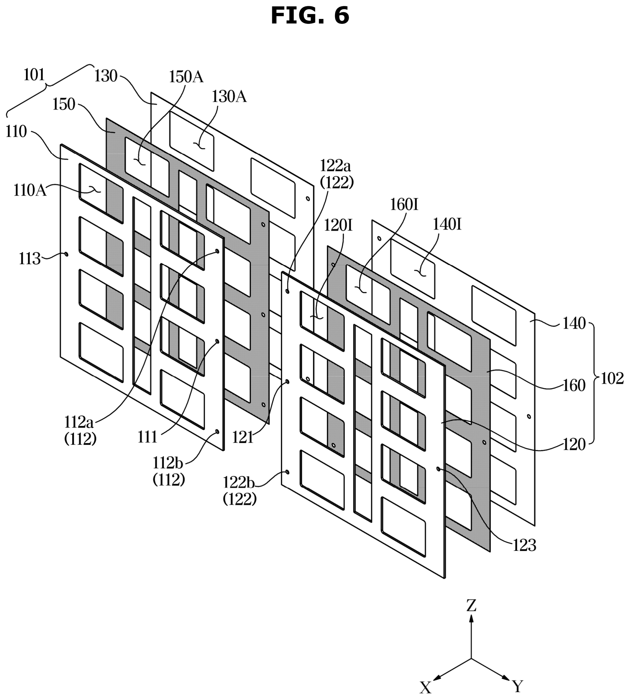

FIG. 5 illustrates a frame in the display apparatus according to one or more embodiments. FIG. 6 is an exploded view of the frame in the display apparatus according to one or more embodiments.

Referring to FIG. 5, the frame 100 according to one or more embodiments may include a plurality of frame openings 100A-100P formed to correspond to the plurality of display modules 30A-30P.

Referring to FIG. 6, the frame 100 according to one or more embodiments may include a first frame 101 and a second frame 102. The first frame 101 and the second frame 102 may be arranged side by side in a horizontal direction.

According to one or more embodiments, the first frame 101 may include a first module attachment layer 110 and a first frame panel 130. The second frame 102 may include a second module attachment layer 120 and a second frame panel 140.

The some display modules 30A-30H among the plurality of display modules 30A-30P may be attached to the first module attachment layer 110. The first module attachment layer 110 may have a first thermal expansion coefficient. The first thermal expansion coefficient of the first module attachment layer 110 may be similar to the thermal expansion coefficient of the substrate 40 of the plurality of display modules 30A-30H. To this end, the first module attachment layer 110 may include a material having a thermal expansion coefficient that is the same or similar to the thermal expansion coefficient of the substrate 40. The first module attachment layer 110 may include carbon fiber reinforced plastics (CFRP).

As the first module attachment layer 110 has the thermal expansion coefficient equal to or similar to that of the substrate 40 of the plurality of display modules 30A-30H, the display apparatus 1 according to one or more embodiments may prevent the plurality of display modules 30A-30H from being damaged while being deformed by heat. The display apparatus 1 according to one or more embodiments may prevent the plurality of display modules 30A-30H from being damaged because the first module attachment layer 110 may be deformed similarly to the plurality of display modules 30A-30H while the plurality of display modules 30A-30H is deformed by heat.

The remaining display modules 30I-30P among the plurality of display modules 30A-30P may be attached to the second module attachment layer 120. The second module attachment layer 120 may have the first thermal expansion coefficient that is the same as the thermal expansion coefficient of the first module attachment layer 110. The first thermal expansion coefficient of the second module attachment layer 120 may be similar to the thermal expansion coefficient of the substrate 40 of the plurality of display modules 30I-30P. To this end, the second module attachment layer 120 may include a material having a thermal expansion coefficient that is the same or similar to that of the substrate 40. The second module attachment layer 120 may include the carbon fiber reinforced plastics (CFRP).

As the second module attachment layer 120 has the thermal expansion coefficient equal to or similar to that of the substrate 40 of the plurality of display modules 30I-30P, the display apparatus 1 according to one or more embodiments may prevent the plurality of display modules 30I-30P from being damaged while being deformed by heat. The display apparatus 1 according to one or more embodiments may prevent the plurality of display modules 30I-30P from being damaged because the second module attachment layer 120 may be deformed similarly to the plurality of display modules 30I-30P while the plurality of display modules 30I-30P is deformed by heat.

The display panel 20 may display the screen using the plurality of display modules 30A-30P. In this case, the sense of unity of the screen may decrease due to seams formed by the gaps formed between the plurality of display modules 30A-30P.

In order to minimize the perception of the seams of the display panel 20, the plurality of display modules 30A-30P may be arranged on the frame 100 to form regular gaps. This is because when the gaps formed by the plurality of display modules 30A-30P are not regular, the perception of the seams due to some gaps may be increased.

The plurality of display modules 30A-30P may be tiled on the frame 100. As the display apparatus 1 is driven, the substrate 40 forming the plurality of display modules 30A-30P may be thermally expanded by heat generated from the display panel 20. Because material properties of the plurality of display modules 30A-30P and material properties of the frame 100 are different, as the plurality of display modules 30A-30P is thermally expanded to sizes different from the frame 100, widths of some of the gaps between the plurality of display modules 30A-30P may be formed irregularly, and the perception of seams may be increased.

The display apparatus 1 according to one or more embodiments may prevent the gaps between the plurality of display modules 30A-30H from being formed irregularly because material properties of the first module attachment layer 110 of the first frame 101 are the same or similar to the material properties of the plurality of display modules 30A-30H. Also, the display apparatus 1 may prevent the gaps between the plurality of display modules 30I-30P from being formed irregularly because material properties of the second module attachment layer 120 of the second frame 102 are the same or similar to the material properties of the plurality of display modules 30I-30P.

That the material properties of the first module attachment layer 110 are similar to the material properties of the plurality of display modules 30A-30H may include that the thermal expansion coefficient, specific heat, and thermal conductivity of the plurality of display modules 30A-30H are similar to those of the first module attachment layer 110. That the material properties of the second module attachment layer 120 are similar to the material properties of the plurality of display modules 30I-30P may include that the thermal expansion coefficient, specific heat, and thermal conductivity of the plurality of display modules 30I-30P are similar to those of the second module attachment layer 120.

As the plurality of display modules 30A-30H is adhered to the first module attachment layer 110 in the first direction X, the display modules 30A-30H and the first module attachment layer 110 may be provided to be expanded to corresponding lengths when the same heat is transferred to the plurality of display modules 30A-30H and the first module attachment layer 110 in a second direction Z and/or third direction Y orthogonal to the first direction X. When the substrate 40 of the plurality of display modules 30A-30H is thermally expanded by heat generated while the display apparatus 1 according to one or more embodiments is driven, the first module attachment layer 110 of the first frame 101 may be thermally expanded to a value equal to or similar to that of the substrate 40.

As the first module attachment layer 110 of the first frame 101, which is a base surface to which the plurality of display modules 30A-30H is adhered, is thermally expanded to the value equal to or similar to that of the substrate 40 of the plurality of display modules 30A-30H, an interval between the gaps formed between the plurality of display modules 30A-30H may be kept the same.

Likewise, as the plurality of display modules 30I-30P is adhered to the second module attachment layer 120 in the first direction X, the display modules 30I-30P and the second module attachment layer 120 may be provided to be expanded to corresponding lengths when the same heat is transferred to the plurality of display modules 30I-30P and the second module attachment layer 120 in the second direction Z and/or the third direction Y orthogonal to the first direction X. When the substrate 40 of the plurality of display modules 30I-30P is thermally expanded by heat generated while the display apparatus 1 according to one or more embodiments is driven, the second module attachment layer 120 of the second frame 102 may be thermally expanded to a value equal to or similar to that of the substrate 40.

As the second module attachment layer 120 of the second frame 102, which is a base surface to which the plurality of display modules 30I-30P is adhered, is thermally expanded to the value equal to or similar to that of the substrate 40 of the plurality of display modules 301-30P, an interval between the gaps formed between the plurality of display modules 30I-30P may be kept the same.

As described above, the interval between the gaps formed between the plurality of display modules 30A-30H attached to the first module attachment layer 110 of the first frame 101 may be kept even when thermally expanded, and the interval between the gaps formed between the plurality of display modules 30I-30P attached to the second module attachment layer 120 of the second frame 102 may be kept even when thermally expanded.

However, an interval between gaps formed between the plurality of display modules 30E, 30F, 30G, and 30H attached to the first frame 101 and the plurality of display modules 30I, 30J, 30K, and 30L attached to the second frame 102 may become large due to thermal expansion, and the perception of seams may be increased. This is because the first module attachment layer 110 is expanded based on a center of the first module attachment layer 110 and the second module attachment layer 120 is expanded based on a center of the second module attachment layer 120.

In a case in which the frame 100 is not divided into the first frame 101 and the second frame 102, because one module attachment layer is expanded based on a center thereof, seams between the plurality of display modules attached to the module attachment layer may be kept substantially equally before and after thermal expansion. However, in a case in which the frame 100 is divided into the first frame 101 and the second frame 102, because the first module attachment layer 110 of the first frame 101 is expanded based on the center of the first module attachment layer 110 and the second module attachment layer 120 of the second frame 102 is expanded based on the center of the second module attachment layer 120, the gaps between the plurality of display modules 30E, 30F, 30G, and 30H attached to the first module attachment layer 110 and the plurality of display modules 30I, 30J, 30k, and 30L attached to the second module attachment layer 120 may become large due to thermal expansion. That is, as the perception of the seams between the plurality of display modules 30E, 30F, 30G, and 30H attached to the first module attachment layer 110 and the plurality of display modules 30I, 30J, 30k, and 30L attached to the second module attachment layer 120 increases, the sense of unity of the screen of the display panel 20 may decrease.

Because the display apparatus 1 according to one or more embodiments may maintain the interval of the gaps formed between the plurality of display modules 30A-30P substantially equally to a state in which the substrate 40 is not thermally expanded, a certain level of seams may be kept, and the sense of unity of the screen of the display panel 20 may be kept. To this end, the display apparatus 1 according to one or more embodiments may form a thermal expansion reference point of the first module attachment layer 110 to an edge of the first module attachment layer 110 adjacent to the second module attachment layer 120, and may form a thermal expansion reference point of the second module attachment layer 120 to an edge of the second module attachment layer 120 adjacent to the first module attachment layer 110. A detailed explanation thereof will be provided later.

Referring to FIG. 6, the first module attachment layer 110 may include an opening 110A corresponding to the frame opening 100A of the first frame 101. The second module attachment layer 120 may include an opening 120I corresponding to the frame opening 1001 of the second frame 102.

The first module attachment layer 110 according to one or more embodiments may include a first hole 111, a third hole 112 spaced apart from the first hole 111 in the second direction Z, and a fifth hole 113 spaced apart from the first hole 111 in the third direction Y. The second module attachment layer 120 may include a second hole 121, a fourth hole 122 spaced apart from the second hole 121 in the second direction Z, and a sixth hole 123 spaced apart from the second hole 121 in the third direction Y.

The first frame 101 according to one or more embodiments may include the first frame panel 130 disposed on one side of the first module attachment layer 110. The first frame panel 130 may be disposed at the rear of the first module attachment layer 110. The first frame panel 130 may be positioned on a side opposite to one side of the first module attachment layer 110 on which the plurality of display modules 30A-30H is attached.

The second frame 102 according to one or more embodiments may include the second frame panel 140 disposed on one side of the second module attachment layer 120. The second frame panel 140 may be disposed at the rear of the second module attachment layer 120. The second frame panel 140 may be positioned on a side opposite to one side of the second module attachment layer 120 on which the plurality of display modules 30I-30P is attached.

The frame 100, which is provided to support the display panel 20, may be provided to have rigidity of a predetermined strength or more. The first frame panel 130 and the second frame panel 140 may include a material with relatively high rigidity for the strength of the frame 100. The first frame panel 130 may be provided to have rigidity greater than that of the first module attachment layer 110, and the second frame panel 140 may be provided to have rigidity greater than that of the second module attachment layer 120. As one or more examples, the first frame panel 130 and the second frame panel 140 may be formed of a metal material having a certain level of rigidity or higher. As one or more examples, the first frame panel 130 and the second frame panel 140 may be formed of steel plates. As one or more examples, the first frame panel 130 and the second frame panel 140 may include stainless steel galvanized cold-rolled steel. As one or more examples, the first frame panel 130 and the second frame panel 140 may include electrogalvanized commercial cold rolled (SECC) steel sheet.

A surface of the first frame panel 130 facing the first module attachment layer 110 may be formed flat without any protruding portions. The first frame panel 130 may be formed flat such that the plurality of display modules 30A-30H may be arranged horizontally. The first frame panel 130 may secure a plane for tiling the plurality of display modules 30A-30H.

A surface of the second frame panel 140 facing the second module attachment layer 120 may be formed flat without any protruding portions. The second frame panel 140 may be formed flat such that the plurality of display modules 30I-30P may be arranged horizontally (disposed adjacently to each other). The second frame panel 140 may secure a plane for tiling the plurality of display modules 30I-30P.

The first frame panel 130 and the second frame panel 140 may have a thermal expansion coefficient different from that of the first module attachment layer 110 and the second module attachment layer 120. That is, the first frame panel 130 and the second frame panel 140 may have a second thermal expansion coefficient different from the first thermal expansion coefficient. The first frame panel 130 and the second frame panel 140 may have a thermal expansion coefficient different from the thermal expansion coefficient of the substrate 40 of the plurality of display modules 30A-30P. The first frame panel 130 and the second frame panel 140 may have a thermal expansion coefficient greater than the thermal expansion coefficient of the first module attachment layer 110 and the second module attachment layer 120. That is, the second thermal expansion coefficient may be provided to be greater than the first thermal expansion coefficient. The first frame panel 130 and the second frame panel 140 may have a thermal expansion coefficient greater than the thermal expansion coefficient of the substrate 40 of the plurality of display modules 30A-30P.

The first frame panel 130 may include an opening 130A corresponding to the frame opening 100A of the first frame 101, and the second frame panel 140 may include an opening 140I corresponding to the frame opening 100I of the second frame 102.

The first frame panel 130 according to one or more embodiments may include holes corresponding to the first hole 111, the third hole 112, and the fifth hole 113 of the first module attachment layer 110. The second frame panel 140 may include holes corresponding to the second hole 121, the fourth hole 122, and the sixth hole 123 of the second module attachment layer 120.

The first frame 101 according to one or more embodiments may include a first adhesive layer 150 provided between the first module attachment layer 110 and the first frame panel 130. The first adhesive layer 150 may be provided to absorb an impact resulting from a difference in a deformation rate of the first module attachment layer 110 due to heat and a deformation rate of the first frame panel 130 due to heat while both the first module attachment layer 110 and the first frame panel 130 are thermally deformed as the heat is generated in the display apparatus 1. The first adhesive layer 150 may be provided to compensate for a difference in thermal expansion coefficient between the first module attachment layer 110 and the first frame panel 130.

The first adhesive layer 150 may include a material having ductility. The first adhesive layer 150 may be provided to have the ductility greater than the ductility of the first module attachment layer 110 and/or the ductility of the first frame panel 130. The first adhesive layer 150 may include a deformable material. The first adhesive layer 150 according to one or more embodiments may include polyurethane foam (PU FOAM).

As one or more examples, while heat is generated in the display apparatus 1, the deformation rate of the first frame panel 130 due to the heat may be greater than the deformation rate of the first module attachment layer 110 due to the heat. While the first frame panel 130 and the first module attachment layer 110 are deformed by the heat generated from the display apparatus 1, a portion of the first adhesive layer 150 that is in contact with the first frame panel 130 may be deformed more than a portion of the first adhesive layer 150 that is in contact with the first module attachment layer 110.

The second frame 102 according to one or more embodiments may include a second adhesive layer 160 provided between the second module attachment layer 120 and the second frame panel 140. The second adhesive layer 160 may be provided to absorb an impact resulting from a difference in a deformation rate of the second module attachment layer 120 due to heat and a deformation rate of the second frame panel 140 due to heat while both the second module attachment layer 120 and the second frame panel 140 are thermally deformed as the heat is generated in the display apparatus 1. The second adhesive layer 160 may be provided to compensate for a difference in thermal expansion coefficient between the second module attachment layer 120 and the second frame panel 140.

The second adhesive layer 160 may include a material having ductility. The second adhesive layer 160 may be provided to have the ductility greater than ductility of the second module attachment layer 120 and/or ductility of the second frame panel 140. The second adhesive layer 160 may include a deformable material. The second adhesive layer 160 according to one or more embodiments may include polyurethane foam (PU FOAM).

As one or more examples, while heat is generated in the display apparatus 1, the deformation rate of the second frame panel 140 due to the heat may be greater than the deformation rate of the second module attachment layer 120 due to the heat. While the second frame panel 140 and the second module attachment layer 120 are deformed by the heat generated from the display apparatus 1, a portion of the second adhesive layer 160 that is in contact with the second frame panel 140 may be deformed more than a portion of the second adhesive layer 160 that is in contact with the second module attachment layer 120.

As the first adhesive layer 150 includes a material having the ductility, when an external force generated from a change in size of the first module attachment layer 110 and the first frame panel 130 during thermal expansion is transmitted to the first adhesive layer 150, the external force may be prevented from being transmitted to the first module attachment layer 110 and the first frame panel 120 as the first adhesive layer 150 itself is deformed. Likewise, as the second adhesive layer 160 includes a material having the ductility, an external force generated from a change in size of the second module attachment layer 120 and the second frame panel 140 during thermal expansion may be prevented from being transmitted to the second module attachment layer 120 and the second frame panel 140, respectively, as the second adhesive layer 160 itself is deformed.

The first adhesive layer 150 may include an opening 150A corresponding to the frame opening 100A of the first frame 101, and the second adhesive layer 160 may include an opening 160I corresponding to the frame opening 100I of the second frame 102.

The first adhesive layer 150 according to one or more embodiments may include holes corresponding to the first hole 111, the third hole 112, and the fifth hole 113 of the first module attachment layer 110. The second adhesive layer 160 may include holes corresponding to the second hole 121, the fourth hole 122, and the sixth hole 123 of the second module attachment layer 120.

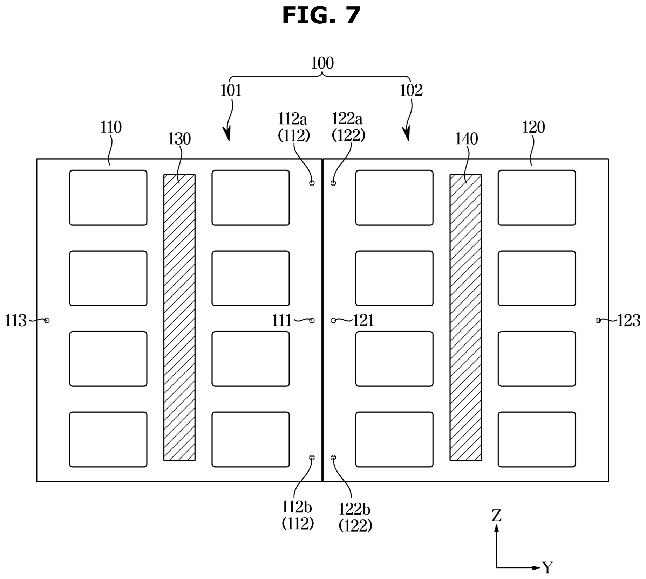

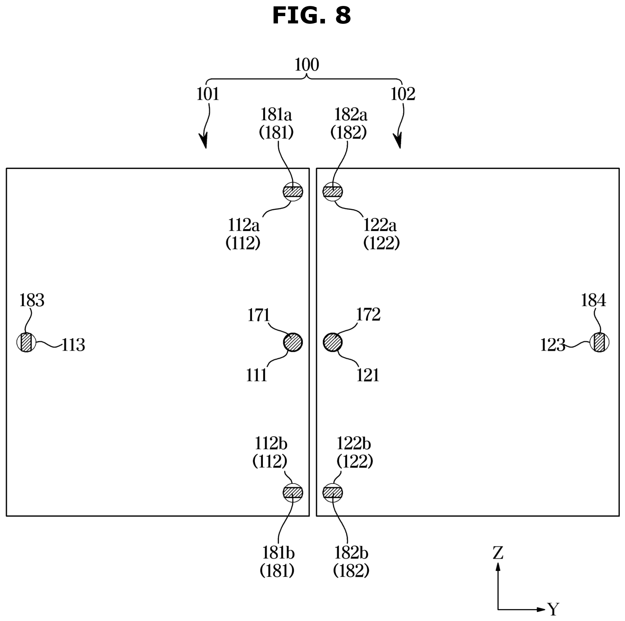

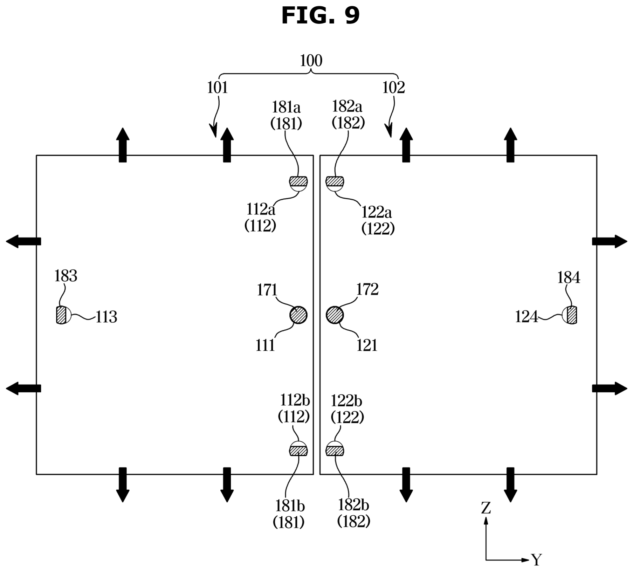

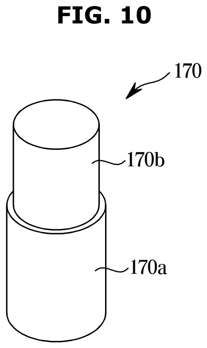

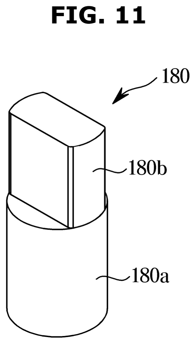

FIG. 7 is a front view of the frame in the display apparatus according to one or more embodiments. FIG. 8 schematically illustrates the frame illustrated in FIG. 7. FIG. 9 schematically illustrates an appearance of the frame when thermally expanded in the display apparatus according to one or more embodiments. FIG. 10 illustrates an example of a fixing member in the display apparatus according to one or more embodiments. FIG. 11 illustrates an example of a fixing member in the display apparatus according to one or more embodiments.

Referring to FIGS. 7 and 8, the first module attachment layer 110 may include the first hole 111, the third hole 112, and the fifth hole 113 formed at positions adjacent to edges of the first module attachment layer 110. The second module attachment layer 120 may include the second hole 121, the fourth hole 122, and the sixth hole 123 formed at positions adjacent to edges of the second module attachment layer 120. The third hole 112 may include an upper third hole 112a spaced apart from the first hole 111 in the second direction (+Z), and a lower third hole 112b spaced apart from the first hole 111 in a fourth direction (-Z) opposite to the second direction. The fourth hole 122 may include an upper fourth hole 122a spaced apart from the second hole 121 in the second direction (+Z), and a hole 122b spaced apart from the second hole 121 in the fourth direction (-Z).

According to one or more embodiments, the first frame 101 may include a first fixing member 171 provided to fix a first portion on the first module attachment layer 110 and a first portion on the first frame panel 130 to prevent the first portion on the first module attachment layer 110 and the first portion on the first frame panel 130 from moving relative to each other.

Likewise, the second frame 102 may include a second fixing member 172 provided to fix a first portion on the second module attachment layer 120 and a first portion on the second frame panel 140 to prevent the first portion on the second module attachment layer 120 and the first portion on the second frame panel 140 from moving relative to each other.

The first portion on the first module attachment layer 110 may represent the first hole 111 of the first module attachment layer 110 or a partial region around the first hole 111. The first portion on the first frame panel 130 may represent a hole or a partial region around the hole of the first frame panel 130 corresponding to the first hole 111 of the first module attachment layer 110.

The first portion on the second module attachment layer 120 may represent the second hole 121 of the second module attachment layer 120 or a partial region around the second hole 121. The first portion on the second frame panel 140 may represent a hole or a partial region around the hole of the second frame panel 140 corresponding to the second hole 121 of the second module attachment layer 120.

The first fixing member 171 may fix the first portion of the first module attachment layer 110 and the first portion of the first frame panel 130 to prevent the first portion of the first module attachment layer 110 and the first portion of the first frame panel 130 corresponding to the first portion of the first module attachment layer 110 in the first direction X from moving relative to each other in the horizontal direction. The first fixing member 171 may restrict the first portion of the first module attachment layer 110 from moving relative to the first portion of the first frame panel 130 in the second direction Z and the third direction Y.

The second fixing member 172 may fix the first portion of the second module attachment layer 120 and the first portion of the second frame panel 140 to prevent the first portion of the second module attachment layer 120 and the first portion of the second frame panel 140 corresponding to the first portion of the second module attachment layer 120 in the first direction X from moving relative to each other in the horizontal direction. The second fixing member 172 may restrict the first portion of the second module attachment layer 120 from moving relative to the first portion of the second frame panel 140 in the second direction Z and the third direction Y.

The first fixing member 171 may be coupled to be fixed to the first frame panel 130 or the first module attachment layer 110. According to one or more embodiments, the first fixing member 171 may be coupled to be fixed to the first portion of the first frame panel 130. The first fixing member 171 may be inserted into the first hole 111 of the first module attachment layer 110, and thereafter disposed in the first hole 111. The first hole 111 may restrain the first fixing member 171 to prevent the first fixing member 171 inserted into the first hole 111 from moving in the second direction Z and the third direction Y. Unlike this, the first fixing member may be coupled to be fixed to the first module attachment layer. In this case, the first frame panel may include the first hole into which the first fixing member is inserted. The first hole may be provided to restrain the first fixing member in the second direction Z and the third direction Y.

The second fixing member 172 may be coupled to be fixed to the second frame panel 140 or the second module attachment layer 120. According to one or more embodiments, the second fixing member 172 may be coupled to be fixed to the first portion of the second frame panel 140. The second fixing member 172 may be inserted into the second hole 121 of the second module attachment layer 120, and thereafter disposed in the second hole 121. The second hole 121 may restrain the second fixing member 172 to prevent the second fixing member 172 inserted into the second hole 121 from moving in the second direction Z and the third direction Y. Unlike this, the second fixing member may be coupled to be fixed to the second module attachment layer. In this case, the second frame panel may include the second hole into which the second fixing member is inserted. The second hole may be provided to restrain the second fixing member in the second direction Z and the third direction Y.

As described above, due to the first hole 111 and the first fixing member 171 inserted into the first hole 111, the first portion of the first module attachment layer 110 and the first portion of the first frame panel 130 may not move relative to each other in the second direction Z and the third direction Y. As the first portion of the first module attachment layer 110 and the first portion of the first frame panel 130 do not move relative to each other in the second direction Z and the third direction Y, the first module attachment layer 110 may be thermally expanded based on the first portion of the first module attachment layer. In other words, the first portion of the first module attachment layer 110 may be a reference point for thermal expansion of the first module attachment layer 110.

Likewise, due to the second hole 121 and the second fixing member 172 inserted into the second hole 121, the first portion of the second module attachment layer 120 and the first portion of the second frame panel 140 may not move relative to each other in the second direction Z and the third direction Y. As the first portion of the second module attachment layer 120 and the first portion of the second frame panel 140 do not move relative to each other in the second direction Z and the third direction Y, the second module attachment layer 120 may be thermally expanded based on the first portion of the second module attachment layer 120. The first portion of the second module attachment layer 120 may be a reference point for thermal expansion of the second module attachment layer 120.

As described above, when the first module attachment layer 110 is thermally expanded based on the first portion of the first module attachment layer 110 and the second module attachment layer 120 is thermally expanded based on the first portion of the second module attachment layer 120, the seams formed in the third direction Y between the plurality of display modules 30E, 30F, 30G, and 30H attached to the first frame 101 and the plurality of display modules 30I, 30J, 30K, and 30L attached to the second frame 102 may be kept substantially equally before and after thermal expansion. Therefore, the sense of unity of the screen of the display panel 20 may be kept.

According to one or more embodiments, the first frame 101 may include a third fixing member 181 provided to restrict relative movement of a second portion on the first module attachment layer 110 in the third direction Y with respect to a second portion on the first frame panel 130, and a fifth fixing member 183 provided to restrict relative movement of a third portion on the first module attachment layer 110 in the second direction Z with respect to a third portion on the first frame panel 130.

Likewise, the second frame 102 may include a fourth fixing member 182 provided to restrict relative movement of a second portion on the second module attachment layer 120 in the third direction Y with respect to a second portion on the second frame panel 140, and a sixth fixing member 184 provided to restrict relative movement of a third portion on the second module attachment layer 120 in the second direction Z with respect to a third portion on the second frame panel 140.

The second portion on the first module attachment layer 110 may represent the third hole 112 spaced apart in the second direction Z from the first hole 111 of the first module attachment layer 110 or a partial region around the third hole 112. The second portion on the first frame panel 130 may represent a hole or a partial region around the hole of the first frame panel 130 corresponding to the third hole 112 of the first module attachment layer 110.

The third portion on the first module attachment layer 110 may represent the fifth hole 113 spaced apart in the third direction Y from the first hole 111 of the first module attachment layer 110 or a partial region around the fifth hole 113. The third portion on the first frame panel 130 may represent a hole or a partial region around the hole of the first frame panel 130 corresponding to the fifth hole 113 of the first module attachment layer 110.

The second portion on the second module attachment layer 120 may represent the fourth hole 122 spaced apart in the second direction Z from the second hole 121 of the second module attachment layer 120 or a partial region around the fourth hole 122. The second portion on the second frame panel 140 may represent a hole or a partial region around the hole of the second frame panel 140 corresponding to the fourth hole 122 of the second module attachment layer 120.

The third portion on the second module attachment layer 120 may represent the sixth hole 123 spaced apart in the third direction Y from the second hole 121 of the second module attachment layer 120 or a partial region around the sixth hole 123. The third portion on the second frame panel 140 may represent a hole or a partial region around the hole of the second frame panel 140 corresponding to the sixth hole 123 of the second module attachment layer 120.

The third fixing member 181 may be coupled to be fixed to the first frame panel 130 or the first module attachment layer 110. According to one or more embodiments, the third fixing member 181 may be coupled to be fixed to the second portion of the first frame panel 130. The third fixing member 181 may be inserted into the third hole 112 of the first module attachment layer 110. The third hole 112 may include an upper third hole 112a and a lower third hole 112b, and the third fixing member 181 may include an upper third fixing member 181a inserted into the upper third hole 112a and a lower third fixing member 181b inserted into the lower third hole 112b. Unlike this, the third fixing member may be coupled to be fixed to the first module attachment layer. In this case, the first frame panel may include a third hole into which the third fixing member is inserted.

According to one or more embodiments, the third fixing member 181 inserted into the third hole 112 may be allowed to move in the second direction Z, and may be restricted from moving in the third direction Y. In other words, the third hole 112 may not restrict movement of the third fixing member 181 inserted into the third hole 112 in the second direction Z with respect to the third hole 112, and may restrict the movement of the third fixing member 181 in the third direction Y with respect to the third hole 112. Accordingly, as illustrated in FIG. 9, when thermally expanded, the third fixing member 181 may move in the second direction Z with respect to the third hole 112.

When the third hole 112 does not restrict the movement of the third fixing member 181 in the third direction Y, the third fixing member 181 may move in the third direction Y when thermally expanded, and accordingly, seams formed in the third direction between the first module attachment layer 110 and the second module attachment layer 120 may become large. In order to prevent this, the third hole 112 may restrict the movement of the third fixing member 181 in the third direction Y.

The fourth fixing member 182 may be coupled to be fixed to the second frame panel 140 or the second module attachment layer 120. According to one or more embodiments, the fourth fixing member 182 may be coupled to be fixed to the second portion of the second frame panel 140. The fourth fixing member 182 may be inserted into the fourth hole 122 of the second module attachment layer 120. The fourth hole 122 may include an upper fourth hole 122a and a lower fourth hole 122b, and the fourth fixing member 182 may include an upper fourth fixing member 182a inserted into the upper fourth hole 122a and a lower fourth fixing member 182b inserted into the lower fourth hole 122b. Unlike this, the fourth fixing member may be coupled to be fixed to the second module attachment layer. In this case, the second frame panel may include a fourth hole into which the fourth fixing member is inserted.

The fourth fixing member 182 inserted into the fourth hole 122 may be allowed to move in the second direction Z, and may be restricted from moving in the third direction Y. In other words, the fourth hole 122 may not restrict movement of the fourth fixing member 182 inserted into the fourth hole 122 in the second direction Z with respect to the fourth hole 122, and may restrict the movement of the fourth fixing member 182 in the third direction Y with respect to the fourth hole 122. Accordingly, as illustrated in FIG. 9, when thermally expanded, the fourth fixing member 182 may move in the second direction Z with respect to the fourth hole 122.

When the fourth hole 122 does not restrict the movement of the fourth fixing member 182 in the third direction Y, the fourth fixing member 182 may move in the third direction Y when thermally expanded, and accordingly, the seams formed in the third direction between the first module attachment layer 110 and the second module attachment layer 120 may become large. In order to prevent this, the fourth hole 122 may restrict the movement of the fourth fixing member 182 in the third direction Y.

According to one or more embodiments, the fifth fixing member 183 inserted into the fifth hole 113 may be allowed to move in the third direction Y, and may be restricted from moving in the second direction Z. In other words, the fifth hole 113 may not restrict movement of the fifth fixing member 183 inserted into the fifth hole 113 in the third direction Y with respect to the fifth hole 113, and may restrict the movement of the fifth fixing member 183 in the second direction Z with respect to the fifth hole 113. Accordingly, as illustrated in FIG. 9, when thermally expanded, the fifth fixing member 183 may move in the third direction Y with respect to the fifth hole 113.

The sixth fixing member 184 inserted into the sixth hole 123 may be allowed to move in the third direction Y, and may be restricted from moving in the second direction Z. In other words, the sixth hole 123 may not restrict movement of the sixth fixing member 184 inserted into the sixth hole 123 in the third direction Y with respect to the sixth hole 123, and may restrict the movement of the sixth fixing member 184 in the second direction Z with respect to the sixth hole 123. Accordingly, as illustrated in FIG. 9, when thermally expanded, the sixth fixing member 184 may move in the third direction Y with respect to the sixth hole 123.

The structures of the first fixing member 171 inserted into the first hole 111 of the first module attachment layer 110 and the second fixing member 172 inserted into the second hole 121 of the second module attachment layer 120 will be described below with reference to FIG. 10. Hereinafter, the fixing member 170 may represent the first fixing member 171 and the second fixing member 172. The first fixing member 171 and the second fixing member 172 may have the same structure.

The fixing member 170 may include a body part 170a and a head part 170b. According to one or more embodiments, the body part 170a may be coupled to the first frame panel 130 or the second frame panel 140. The head part 170b may be provided in a substantially cylindrical shape. A cross section of the head part 170b may be provided to correspond to the first hole 111 or the second hole 121.

According to one or more embodiments, as illustrated in FIG. 10, the fixing member 170 may be provided in a pin structure. In this case, the body part 170a of the fixing member 170 may be coupled by being inserted into the hole of the first frame panel 130 or the hole of the second frame panel 140. Unlike this, the body part 170a of the fixing member 170 may be coupled by being inserted into the hole of the first module attachment layer 110 or the hole of the second attachment layer 120.

Unlike this, the fixing member 170 may be provided in a screw structure. In this case, the fixing member may be coupled to be fixed to the first frame panel 130 or the second frame panel 140, or may be coupled to be fixed to the first module attachment layer 110 or the second module attachment layer 120.

The fixing member 170 may also be provided in a stapler structure. The fixing member 170 may also be provided as an adhesive chemically adhering the first module attachment layer 110 and the first frame panel 130 and chemically adhering the second module attachment layer 120 and the second frame panel 140.

The structures of the third fixing member 181 inserted into the third hole 112 and the fifth fixing member 183 inserted into the fifth hole 113 of the first module attachment layer 110, and the fourth fixing member 182 inserted into the fourth hole 122 and the sixth fixing member 184 inserted into the sixth hole 123 of the second module attachment layer 120 will be described below with reference to FIG. 11. Hereinafter, a fixing member 180 may represent the third fixing member 181, the fourth fixing member 182, the fifth fixing member 183, and the fourth fixing member 184. The third fixing member 181, the fourth fixing member 182, the fifth fixing member 183, and the fourth fixing member 184 may have the same structure.

Referring to FIG. 11, the fixing member 180 may include a body part 180a provided in a substantially cylindrical shape, and a head part 180b protruding from the body part 180a and having at least one flat side.

According to one or more embodiments, the head part 180b may include a first portion having a width corresponding to a diameter of the third hole 112, the fourth hole 122, the fifth hole 113, and the sixth hole 123, and a second portion having a width smaller than the diameter of the third hole 112, the fourth hole 122, the fifth hole 113, and the sixth hole 123.

The fixing member 180 is disposed such that the second portion of the head part 180b directs to the second direction Z or the third direction Y within the third hole 112, the fourth hole 122, the fifth hole 113, and the sixth hole 123. In a case in which the second portion of the head part 180b directs to the second direction Z, the fixing member 180 may be allowed to move in the second direction Z within the third hole 112, the fourth hole 122, the fifth hole 113, and the sixth hole 123, and may be restricted from moving in the third direction Y. In a case in which the second portion of the head part 180b directs to the third direction Y, the fixing member 180 may be allowed to move in the third direction Y within the third hole 112, the fourth hole 122, the fifth hole 113, and the sixth hole 123, and may be restricted from moving in the second direction Z.

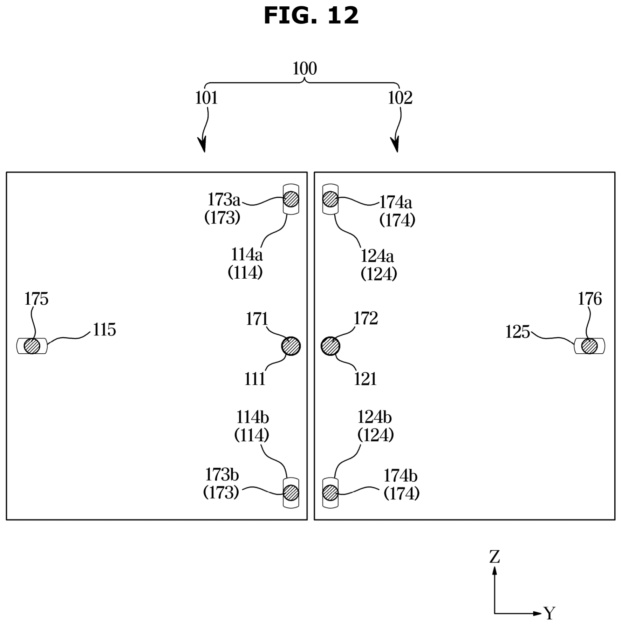

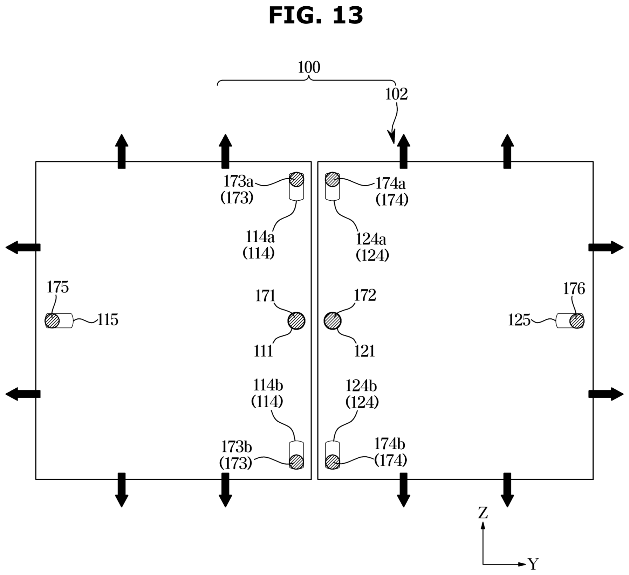

FIG. 12 schematically illustrates a frame in the display apparatus according to one or more embodiments. FIG. 13 schematically illustrates an appearance of the frame when thermally expanded in the display apparatus according to one or more embodiments.

Referring to FIGS. 12 and 13, the first frame 101 may include the first fixing member 171, a third fixing member 173, and a fifth fixing member 175. The first frame 101 may also include the first hole 111, a first guide hole 114, and a third guide hole 115. The second frame 102 may include the second fixing member 172, a fourth fixing member 174, and a sixth fixing member 176. The second frame 101 may also include a second guide hole 124 and a fourth guide hole 125.

The first fixing member 171, the second fixing member 172, the third fixing member 173, the fourth fixing member 174, the fifth fixing member 175, and the sixth fixing member 176 may have the same structure as that of the fixing member 170 described above.

According to one or more embodiments, the first module attachment layer 110 may include the first guide hole 114 into which the third fixing member 173 is inserted and extending in the second direction Z, and the third guide hole 115 into which the fifth fixing member 175 is inserted and extending in the third direction Y. The second module attachment layer 120 may include the second guide hole 124 into which the fourth fixing member 174 is inserted and extending in the second direction Z, and the fourth guide hole 125 into which the sixth fixing member 176 is inserted and extending in the third direction Y.

Referring to FIGS. 12 and 13, the first guide hole 114 may guide the third fixing member 173 to move in the second direction Z when the first frame 101 is thermally expanded. The first guide hole 114 may restrict movement of the third fixing member 173 in the third direction Y when the first frame 101 is thermally expanded. The second guide hole 124 may guide the fourth fixing member 174 to move in the second direction Z when the second frame 102 is thermally expanded. The second guide hole 124 may restrict movement of the fourth fixing member 174 in the third direction Y when the second frame 102 is thermally expanded. The third guide hole 115 may guide the fifth fixing member 175 to move in the third direction Y when the first frame 101 is thermally expanded. The third guide hole 115 may restrict movement of the fifth fixing member 175 in the second direction Z when the first frame 101 is thermally expanded. The fourth guide hole 125 may guide the sixth fixing member 176 to move in the third direction Y when the second frame 102 is thermally expanded. The fourth guide hole 125 may restrict movement of the sixth fixing member 176 in the second direction Z when the second frame 102 is thermally expanded.

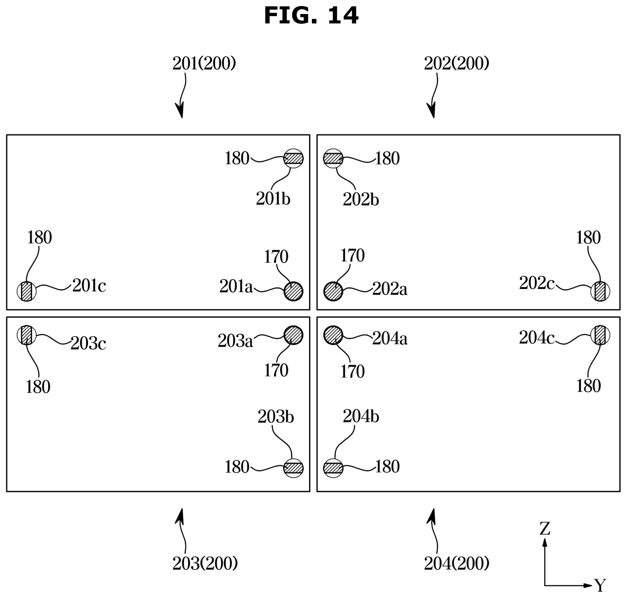

FIG. 14 schematically illustrates a frame in the display apparatus according to one or more embodiments.

Referring to FIG. 14, the display apparatus 1 according to one or more embodiments may include a frame 200 arranged horizontally in the form of a 2*2 matrix. The frame 200 may include a first frame 201, a second frame 202, a third frame 203, and a fourth frame 204.

The first frame 201 may include a first hole 201a provided to restrain the first fixing member 170 in the second direction Z and the third direction Y, a second hole 201b provided to restrain the second fixing member 180 in the third direction Y, and a third hole 201c provided to restrain the second fixing member 180 in the second direction Z.

The second frame 202 may include a first hole 202a provided to restrain the first fixing member 170 in the second direction Z and the third direction Y, a second hole 202b provided to restrain the second fixing member 180 in the third direction Y, and a third hole 202c provided to restrain the second fixing member 180 in the second direction Z.

The third frame 203 may include a first hole 203a provided to restrain the first fixing member 170 in the second direction Z and the third direction Y, a second hole 203b provided to restrain the second fixing member 180 in the third direction Y, and a third hole 203c provided to restrain the second fixing member 180 in the second direction Z.

The fourth frame 204 may include a first hole 204a provided to restrain the first fixing member 170 in the second direction Z and the third direction Y, a second hole 204b provided to restrain the second fixing member 180 in the third direction Y, and a third hole 204c provided to restrain the second fixing member 180 in the second direction Z.

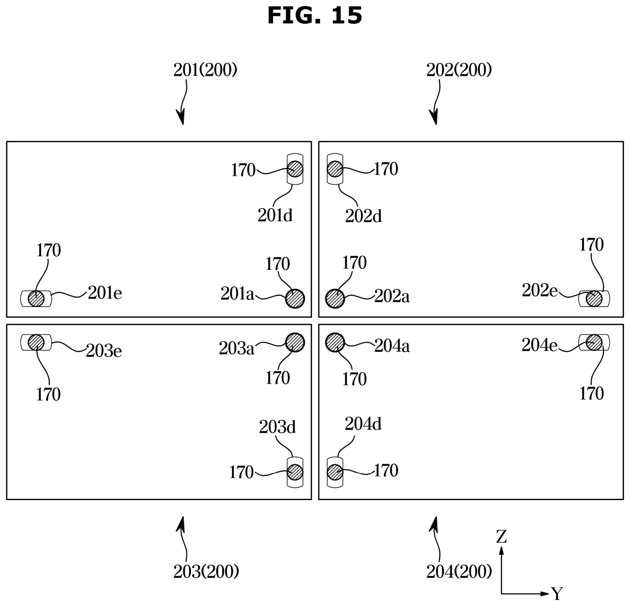

FIG. 15 schematically illustrates a frame in the display apparatus according to one or more embodiments.

Referring to FIG. 15, the first frame 201 may include the first hole 201a provided to restrain the first fixing member 170 in the second direction Z and the third direction Y, a first guide hole 201d provided to guide the first fixing member 170 to move in the second direction Z, and a second guide hole 201e provided to guide the first fixing member 170 to move in the third direction Y.

The second frame 202 may include the first hole 202a provided to restrain the first fixing member 170 in the second direction Z and the third direction Y, a first guide hole 202d provided to guide the first fixing member 170 to move in the second direction Z, and a second guide hole 202e provided to guide the first fixing member 170 to move in the third direction Y.

The third frame 203 may include the first hole 203a provided to restrain the first fixing member 170 in the second direction Z and the third direction Y, a first guide hole 203d provided to guide the first fixing member 170 to move in the second direction Z, and a second guide hole 203e provided to guide the first fixing member 170 to move in the third direction Y.

The fourth frame 204 may include the first hole 204a provided to restrain the first fixing member 170 in the second direction Z and the third direction Y, a first guide hole 204d provided to guide the first fixing member 170 to move in the second direction Z, and a second guide hole 204e provided to guide the first fixing member 170 to move in the third direction Y.

A display apparatus 1 according to one or more embodiments includes a plurality of display modules 30A-30P, and a frame 100 provided to support the plurality of display modules so that the plurality of display modules is arranged horizontally in the form of an M*N matrix. The frame includes a first module attachment layer 110 provided such that the some display modules 30A-30H among the plurality of display modules are attached thereto and having a first thermal expansion coefficient. The frame further includes a first frame panel 130 coupled to the first module attachment layer and having a second thermal expansion coefficient different from the first thermal expansion coefficient. The frame further includes a second module attachment layer 120 provided such that the remaining display modules 30I-30P of the plurality of display modules are attached thereto, having the first thermal expansion coefficient, and arranged horizontally with the first module attachment layer. The frame further includes a second frame panel 140 coupled to the second module attachment layer, having the second thermal expansion coefficient, and arranged horizontally with the first frame panel. The frame further includes a first fixing member 171 provided to fix a first portion (in the vicinity of the first hole 111) on the first module attachment layer and a first portion (in the vicinity of the first hole 111) on the first frame panel 130 so that the first portion on the first module attachment layer and the first portion on the first frame panel do not move relative to each other as the first module attachment layer and the first frame panel are thermally expanded, and a second fixing member 172 provided to fix a first portion (in the vicinity of the second hole 121) on the second module attachment layer 120 and a first portion (in the vicinity of the second hole 121) on the second frame panel 140 so that the first portion on the second module attachment layer 120 and the first portion on the second frame panel 120 do not move relative to each other as the second module attachment layer and the second frame panel are thermally expanded.

The first fixing member may restrict relative movement of the first portion on the first module attachment layer with respect to the first portion on the first frame panel in a first direction Z and a second direction Y intersecting the first direction.

The second fixing member may restrict relative movement of the first portion on the second module attachment layer with respect to the first portion on the second frame panel in the first direction and the second direction.

The frame may further include a third fixing member 181 provided to restrict relative movement of a second portion on the first module attachment layer, which is spaced apart from the first portion on the first module attachment layer in the first direction, with respect to a second portion on the first frame panel, which is spaced apart from the first portion on the first frame panel in the first direction, in the second direction.

The frame may further include a fourth fixing member 182 provided to restrict relative movement of a second portion on the second module attachment layer, which is spaced apart from the first portion on the second module attachment layer in the first direction, with respect to a second portion on the second frame panel, which is spaced apart from the first portion on the second frame panel in the first direction, in the second direction.

The frame may further include a fifth fixing member 183 provided to restrict relative movement of a third portion on the first module attachment layer, which is spaced apart from the first portion on the first module attachment layer in the second direction, with respect to a third portion on the first frame panel, which is spaced apart from the first portion on the first frame panel in the second direction, in the first direction.

The frame may further include a sixth fixing member 184 provided to restrict relative movement of a third portion on the second module attachment layer, which is spaced apart from the first portion on the second module attachment layer in the second direction, with respect to a third portion on the second frame panel, which is spaced apart from the first portion on the second frame panel in the second direction, in the first direction.

The first module attachment layer may include a first hole into which the first fixing member is inserted.

The second module attachment layer may include a second hole into which the second fixing member is inserted.

The first hole may restrain the first fixing member in the first direction and the second direction.

The second hole may restrain the second fixing member in the first direction and the second direction.

The first fixing member may include a first body part coupled to the first frame panel and a first head part having a circle-shaped (circular) cross section corresponding to the first hole.

The second fixing member may include a second body part coupled to the second frame panel and a second head part having a circle-shaped (circular) cross section corresponding to the second hole.

The first module attachment layer may further include a third hole into which the third fixing member is inserted and a fifth hole into which the fifth fixing member is inserted.

The second module attachment layer may further include a fourth hole into which the fourth fixing member is inserted and a sixth hole into which the sixth fixing member is inserted.

The third fixing member may include a third body part coupled to the first frame panel, and a third head part having a width smaller than a diameter of the third hole in the first direction and a width corresponding to the diameter of the third hole in the second direction.

The fourth fixing member may include a fourth body part coupled to the second frame panel, and a fourth head part having a width smaller than a diameter of the fourth hole in the first direction and a width corresponding to the diameter of the fourth hole in the second direction.

The fifth fixing member may include a fifth body part coupled to the first frame panel, and a fifth head part having a width corresponding to a diameter of the fifth hole in the first direction and a width smaller than the diameter of the fifth hole in the second direction.

The sixth fixing member may include a sixth body part coupled to the second frame panel, and a sixth head part having a width corresponding to a diameter of the sixth hole in the first direction and a width smaller than the diameter of the sixth hole in the second direction.

The first module attachment layer may further include a first guide hole into which the third fixing member is inserted and extending in the first direction.

The second module attachment layer may further include a second guide hole into which the fourth fixing member is inserted and extending in the first direction.

The first guide hole may guide the third fixing member to move in the first direction when thermally expanded.

The second guide hole may guide the fourth fixing member to move in the first direction when thermally expanded.

The first module attachment layer may further include a third guide hole into which the fifth fixing member is inserted and extending in the second direction.

The second module attachment layer may further include a fourth guide hole into which the sixth fixing member is inserted and extending in the second direction.

The third guide hole may guide the fifth fixing member to move in the second direction when thermally expanded.

The fourth guide hole may guide the sixth fixing member to move in the second direction when thermally expanded.

Each of the plurality of display modules may include a substrate including a mounting surface on which a plurality of inorganic light emitting elements is mounted, and a rear surface disposed on an opposite side of the mounting surface.

The first module attachment layer and the second module attachment layer may include a material having material properties similar to material properties of the substrate.

The frame may further include a first adhesive layer disposed between the first module attachment layer and the first frame panel to adhere the first module attachment layer and the first frame panel.

The frame may further include a second adhesive layer disposed between the second module attachment layer and the second frame panel to adhere the second module attachment layer and the second frame panel.

Ductility of the first adhesive layer may be provided to be greater than ductility of the first module adhesive layer and ductility of the first frame panel.

Ductility of the second adhesive layer may be provided to be greater than ductility of the second module adhesive layer and ductility of the second frame panel.

The first thermal expansion coefficient may be provided to be less than the second thermal expansion coefficient.

A display apparatus 1 according to one or more embodiments includes a plurality of display modules 30A-30P, and a frame 200 provided to support the plurality of display modules so that the plurality of display modules is arranged horizontally in the form of an M*N matrix. The frame includes a plurality of module attachment layers to which the plurality of display modules is attached, having a first thermal expansion coefficient and arranged horizontally in the form of a 2*2 matrix, a plurality of frame panels coupled to the plurality of module attachment layers, having a second thermal expansion coefficient different from the first thermal expansion coefficient, and arranged horizontally in the form of a 2*2 matrix, and a plurality of fixing members provided to fix first portions 201a, 201b, 201c, and 201d of the plurality of respective module attachment layers and first portions of the plurality of respective frame panels so that the first portions of the plurality of respective module attachment layers and the first portions of the plurality of respective frame panels corresponding to the first portions of the plurality of respective module attachment layers do not move relative to each other in a horizontal direction.

The plurality of fixing members 170 may include a plurality of first fixing members provided to restrict relative movement of the first portions of the plurality of respective module attachment layers with respect to the first portions of the plurality of respective frame panels in a first direction Z and a second direction Y intersecting the first direction.

The plurality of fixing members may include a plurality of second fixing members provided to restrict relative movement of second portions of the plurality of respective module attachment layers, which are spaced apart from the first portions of the plurality of respective module attachment layers in the first direction, with respect to second portions of the plurality of respective frame panels, which are spaced apart from the first portions of the plurality of respective frame panels in the first direction, in the second direction.

The plurality of fixing members may include a plurality of third fixing members provided to restrict relative movement of third portions of the plurality of respective module attachment layers, which are spaced apart from the first portions of the plurality of respective module attachment layers in the second direction, with respect to third portions of the plurality of respective frame panels, which are spaced apart from the first portions of the plurality of respective frame panels in the second direction, in the first direction.

The plurality of module attachment layers may include a plurality of first holes into which the plurality of first fixing members is respectively inserted, and a plurality of second holes into which the plurality of second fixing members is respectively inserted.

The plurality of first holes may respectively restrain the plurality of first fixing members in the first direction and the second direction.

The plurality of second holes may respectively restrain the plurality of second fixing members in the first direction or the second direction.

The plurality of module attachment layers may include a plurality of first guide holes into which the plurality of second fixing members is respectively inserted, and a plurality of second guide holes into which the plurality of third fixing members is respectively inserted.

The plurality of first guide holes may respectively guide the plurality of second fixing members to move in the first direction when thermally expanded.

The plurality of second guide holes may respectively guide the plurality of third fixing members to move in the second direction when thermally expanded.

The present disclosure can provide a display apparatus capable of preventing increase in seams that can occur between a plurality of display modules by keeping gaps between the plurality of display modules due to thermal expansion at a certain level.

The present disclosure can provide a display apparatus, despite including a plurality of frames, capable of preventing seams between a plurality of display modules supported by the plurality of frames from increasing due to thermal expansion.

While example embodiments have been particularly illustrated and described above, it will be apparent to those skilled in the art that modifications and variations in form and details may be made therein without departing from the spirit and scope of the following claims.

## Claims

1. A display apparatus comprising:
a plurality of display modules; and
a frame supporting the plurality of display modules in a matrix arrangement, wherein the frame comprises:
a first module attachment layer to which some display modules among the plurality of display modules are attached and having a first thermal expansion coefficient;
a first frame panel coupled to the first module attachment layer and having a second thermal expansion coefficient different from the first thermal expansion coefficient;
a second module attachment layer to which remaining display modules of the plurality of display modules are attached, having the first thermal expansion coefficient, and disposed adjacently with the first module attachment layer;
a second frame panel coupled to the second module attachment layer, having the second thermal expansion coefficient, and disposed adjacently with the first frame panel;
a first fixing member configured to fix a first portion on the first module attachment layer and a first portion on the first frame panel so that the first portion on the first module attachment layer and the first portion on the first frame panel do not move relative to each other as the first module attachment layer and the first frame panel thermally expand; and
a second fixing member configured to fix a first portion on the second module attachment layer and a first portion on the second frame panel so that the first portion on the second module attachment layer and the first portion on the second frame panel do not move relative to each other as the second module attachment layer and the second frame panel thermally expand.

2. The display apparatus according to claim 1, wherein the first fixing member is configured to restrict relative movement of the first portion on the first module attachment layer with respect to the first portion on the first frame panel in a first direction and a second direction intersecting the first direction; and
wherein the second fixing member is configured to restrict relative movement of the first portion on the second module attachment layer with respect to the first portion on the second frame panel in the first direction and the second direction.

3. The display apparatus according to claim 2, wherein the frame further comprises:
a third fixing member configured to restrict relative movement of a second portion on the first module attachment layer with respect to a second portion on the first frame panel in the second direction, wherein the second portion of the first module attachment layer is spaced apart from the first portion on the first module attachment layer in the first direction, and the second portion of the first frame panel is spaced apart from the first portion on the first frame panel in the first direction; and
a fourth fixing member configured to restrict relative movement of a second portion on the second module attachment layer with respect to a second portion on the second frame panel in the second direction, wherein the second portion of the second module attachment layer is spaced apart from the first portion on the second module attachment layer in the first direction, and the second portion on the second frame panel is spaced apart from the first portion on the second frame panel in the first direction.

4. The display apparatus according to claim 3, wherein the frame further comprises:
a fifth fixing member configured to restrict relative movement of a third portion on the first module attachment layer with respect to a third portion on the first frame panel in the first direction, wherein the third portion on the first module attachment layer is spaced apart from the first portion on the first module attachment layer in the second direction, and the third portion on the first frame panel is spaced apart from the first portion on the first frame panel in the second direction, and
a sixth fixing member configured to restrict relative movement of a third portion on the second module attachment layer with respect to a third portion on the second frame panel in the first direction, wherein the third portion on the second module attachment layer is spaced apart from the first portion on the second module attachment layer in the second direction, and the third portion on the second frame panel is spaced apart from the first portion on the second frame panel in the second direction.

5. The display apparatus according to claim 4, wherein the first module attachment layer comprises a first hole in which the first fixing member is disposed,
wherein the second module attachment layer comprises a second hole in which the second fixing member is disposed,
wherein the first hole restrains the first fixing member in the first direction and the second direction, and
wherein the second hole restrains the second fixing member in the first direction and the second direction.

6. The display apparatus according to claim 5, wherein the first fixing member comprises a first body part coupled to the first frame panel and a first head part having a circular cross section corresponding to the first hole, and
wherein the second fixing member comprises a second body part coupled to the second frame panel and a second head part having a circular cross section corresponding to the second hole.

7. The display apparatus according to claim 5, wherein the first module attachment layer further comprises a third hole in which the third fixing member is disposed and a fifth hole in which the fifth fixing member is disposed, and
wherein the second module attachment layer further comprises a fourth hole in which the fourth fixing member is disposed and a sixth hole in which the sixth fixing member is disposed.

8. The display apparatus according to claim 7,
wherein the third fixing member comprises a third body part coupled to the first frame panel, and a third head part having a width smaller than a diameter of the third hole in the first direction and a width corresponding to the diameter of the third hole in the second direction, and
wherein the fourth fixing member comprises a fourth body part coupled to the second frame panel, and a fourth head part having a width smaller than a diameter of the fourth hole in the first direction and a width corresponding to the diameter of the fourth hole in the second direction.

9. The display apparatus according to claim 7,
wherein the fifth fixing member comprises a fifth body part coupled to the first frame panel, and a fifth head part having a width corresponding to a diameter of the fifth hole in the first direction and a width smaller than the diameter of the fifth hole in the second direction, and
wherein the sixth fixing member comprises a sixth body part coupled to the second frame panel, and a sixth head part having a width corresponding to a diameter of the sixth hole in the first direction and a width smaller than the diameter of the sixth hole in the second direction.

10. The display apparatus according to claim 5, wherein the first module attachment layer further comprises a first guide hole in which the third fixing member is disposed and extending in the first direction,
wherein the second module attachment layer further comprises a second guide hole in which the fourth fixing member is disposed and extending in the first direction,
wherein the first guide hole is configured to guide the third fixing member to move in the first direction when thermally expanded, and
wherein the second guide hole is configured to guide the fourth fixing member to move in the first direction when thermally expanded.

11. The display apparatus according to claim 10, wherein the first module attachment layer further comprises a third guide hole in which the fifth fixing member is disposed and extending in the second direction,
wherein the second module attachment layer further comprises a fourth guide hole in which the sixth fixing member is disposed and extending in the second direction,
wherein the third guide hole is configured to guide the fifth fixing member to move in the second direction when thermally expanded, and
wherein the fourth guide hole is configured to guide the sixth fixing member to move in the second direction when thermally expanded.

12. The display apparatus according to claim 1, wherein each of the plurality of display modules comprises a substrate comprising a mounting surface on which a plurality of inorganic light emitting elements is disposed, and a rear surface disposed on an opposite side of the mounting surface.

13. The display apparatus according to claim 1, wherein the frame further comprises:
a first adhesive layer between the first module attachment layer and the first frame panel to adhere the first module attachment layer and the first frame panel, and
a second adhesive layer between the second module attachment layer and the second frame panel to adhere the second module attachment layer and the second frame panel.

14. The display apparatus according to claim 13, wherein a ductility of the first adhesive layer is greater than a ductility of the first module attachment layer and a ductility of the first frame panel, and
wherein a ductility of the second adhesive layer is greater than a ductility of the second module attachment layer and a ductility of the second frame panel.

15. The display apparatus according to claim 1, wherein the first thermal expansion coefficient is less than the second thermal expansion coefficient.
